(19) Europäisches Patentamt / European Patent Office / Office européen des brevets

(11) **EP 2 560 310 A1**

(12) **EUROPEAN PATENT APPLICATION**

(43) Date of publication:
**20.02.2013 Bulletin 2013/08**

(51) Int Cl.:
**H04L 1/00** *(2006.01)*

(21) Application number: **11008671.7**

(22) Date of filing: **28.10.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **17.08.2011 EP 11177841**

(71) Applicant: **Panasonic Corporation
Kadoma-shi
Osaka 571-8501 (JP)**

(72) Inventor: **Petrov, Mihail
63225 Langen (DE)**

(74) Representative: **Grünecker, Kinkeldey,
Stockmair & Schwanhäusser
Leopoldstrasse 4
80802 München (DE)**

(54) **Cyclic-block permutations for spatial multiplexing with quasi-cyclic LDPC codes**

(57) The present invention relates to bit interleaving and de-interleaving of quasi-cyclic low-density parity-check (QC-LDPC) codes and discloses an interleaving scheme that allows for a matching of the importance level of the cyclic blocks and the robustness of the constellation word bits to which they are mapped. A Monte-Carlo approach is employed for obtaining permutations for re-arranging the sequence of cyclic blocks within a codeword such that the block-error rate is minimized. Specific optimized permutations are provided for the three spatial-multiplexing configurations, three transmission power ratios, and seven QC-LDPC codes used in the DVB-NGH standard.

# Fig. 21

Printed by Jouve, 75001 PARIS (FR)

**Description**

TECHNICAL FIELD

The present invention relates to the field of digital communications, and more specifically to bit interleavers and de-interleavers for bit-interleaved coding and modulation systems with quasi-cyclic low-density parity-check codes, QAM modulation, and spatial multiplexing for two transmit antennas, as well as to corresponding methods, transmitters, and receivers.

BACKGROUND OF THE INVENTION

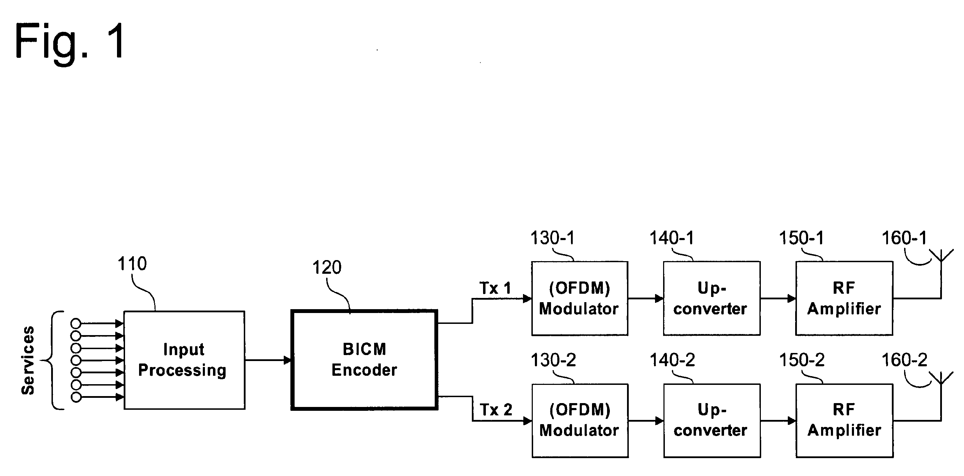

Figure 1 is a block diagram of a transmitter-side communication chain involving bit-interleaved coding and modulation (BICM) with spatial multiplexing over two transmit antennas (160-1, 160-2). The input processing unit (110) formats the input bitstreams into blocks of a predetermined length called baseband frames. The BICM encoder (120) converts the baseband frames into a plurality of complex-valued data streams, the number of data streams being equal to the number of transmit antennas. Each stream is further processed by a chain comprising at least a modulator (130-1, 130-2), an up-converter (140-1, 140-2) from digital baseband to analog RF, and a radio-frequency RF power amplifier (150-1, 150-2). The modulator (130-1, 130-2) uses e.g. orthogonal frequency-division multiplexing (OFDM) modulation and typically includes time and frequency interleaving for increased diversity.

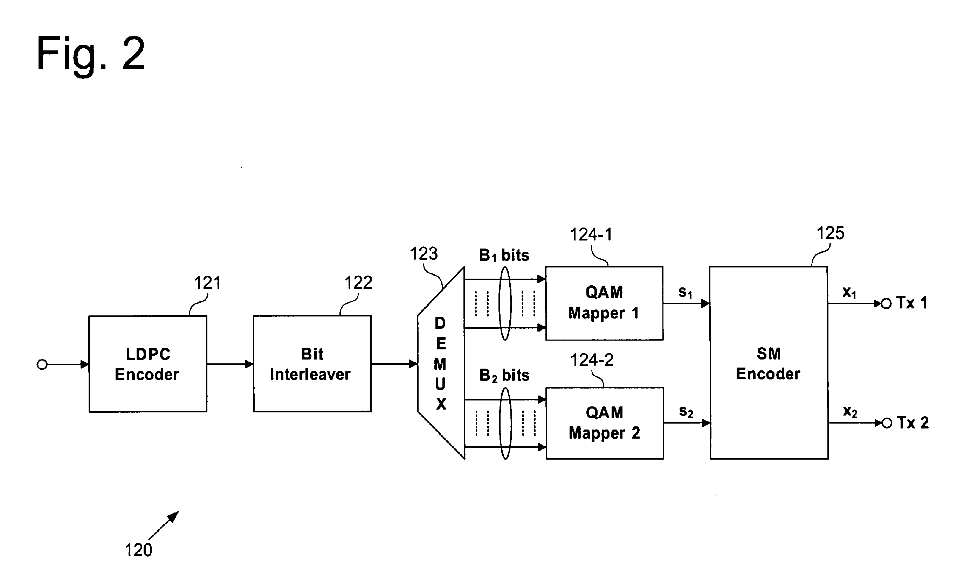

Figure 2 is the block diagram of a BICM encoder (120) for spatial multiplexing over two transmit antennas. The input blocks, i.e. baseband frames, are encoded by the low-density parity-check (LDPC) encoder (121) and fed to bit interleaver (122), which applies a block permutation to the bits of each LDPC codeword. The bit-interleaved LDPC codeword is demultiplexed into two bit streams by demultiplexer DEMUX (123). The bit streams are then mapped to complex symbols by a constellation mapper (124-1, 124-2), which employs quadrature amplitude modulation QAM, and further encoded by an optional spatial-multiplexing SM encoder (125). The SM encoder (125) typically provides for multiplying the vector of two complex input signals by an orthogonal square matrix.

The components of the BICM encoder in Figure 2 will now be explained in more detail.

The LDPC encoder (121) encodes baseband frames according to a specified LDPC code. The present invention is specifically designed for LDPC block codes with staircase parity structure, as encountered in the DVB-S2, DVB-T2 and DVB-C2 standards. More details will be given below.

An LDPC block code is a linear error-correcting code that is fully defined by its parity-check matrix (PCM), which is a binary sparse matrix that represents the connection of the codeword bits (also referred to as bit nodes or variable nodes) to the parity checks (also referred to as check nodes CN). The columns and the rows of the PCM correspond to the variable nodes and the check nodes, respectively. Connections of the variable nodes to the check nodes are represented by "1" entries in the PCM.

Quasi-cyclic (QC) LDPC codes have a structure that makes them particularly suitable for hardware implementation. In fact, most if not all standards today use quasi-cyclic LDPC codes. The PCM of such a code has a special structure consisting of circulant matrices (also referred to as circulants). A circulant is a square matrix in which each row is a cyclic shift of the previous row with one position, and can have one, two, or more folded diagonals.

The size of each circulant is QxQ, where Q is called the cyclic factor of the LDPC code. Such a quasi-cyclic structure allows Q check nodes to be processed in parallel, which is clearly advantageous for an efficient hardware implementation. The PCM of a quasi-cyclic LDPC code has therefore QM rows and QN columns, a codeword consisting of N blocks of Q bits. A Q-bit block is referred to as a quasi-cyclic block or simply cyclic block throughout this document and is abbreviated as QB.

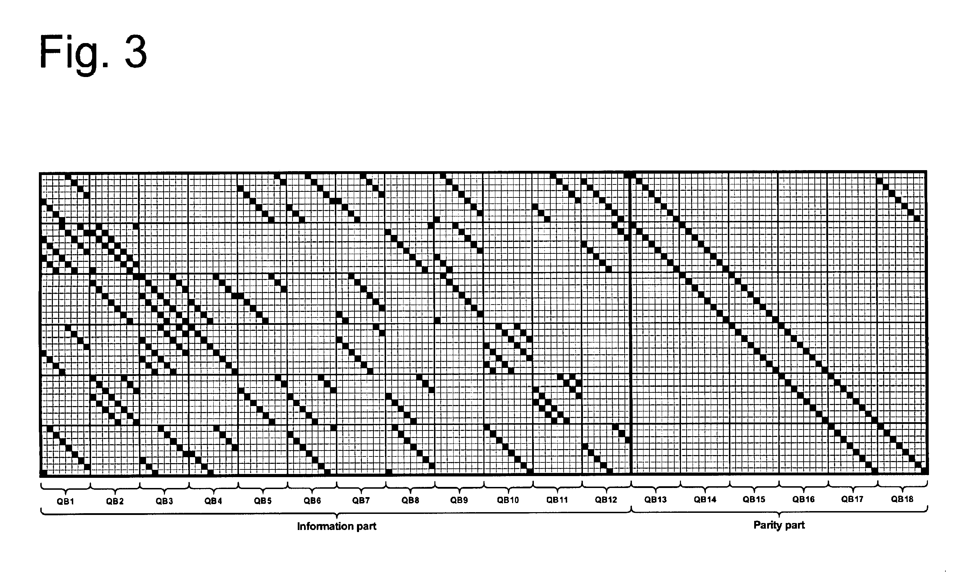

Figure 3 shows the PCM of an example LDPC code with M=6, N=18, and Q=8, the PCM having circulants with one or two diagonals. This code encodes a block of 8x12=96 bits to a codeword of 8x18=144 bits, having therefore a code rate of 2/3.

The code whose PCM is shown in Figure 3 belongs to a special family of QC LDPC codes called repeat-accumulate (RA) QC LDPC codes. These codes are well known for their ease of encoding and are encountered in a large number of standards, such as the second-generation DVB standards: DVB-S2, DVB-T2 and DVB-C2.

In the following, the definition of the repeat-accumulate quasi-cyclic LDPC codes used in the DVB-S2, DVB-T2 and DVB-C2 family of standards, as introduced in Section 5.3.2 and Annexes B and C of the DVB-S2 standard ETSI EN 302 307, V1.2.1 (August 2009), will be discussed. In this family of standards the cyclic factor Q is 360.

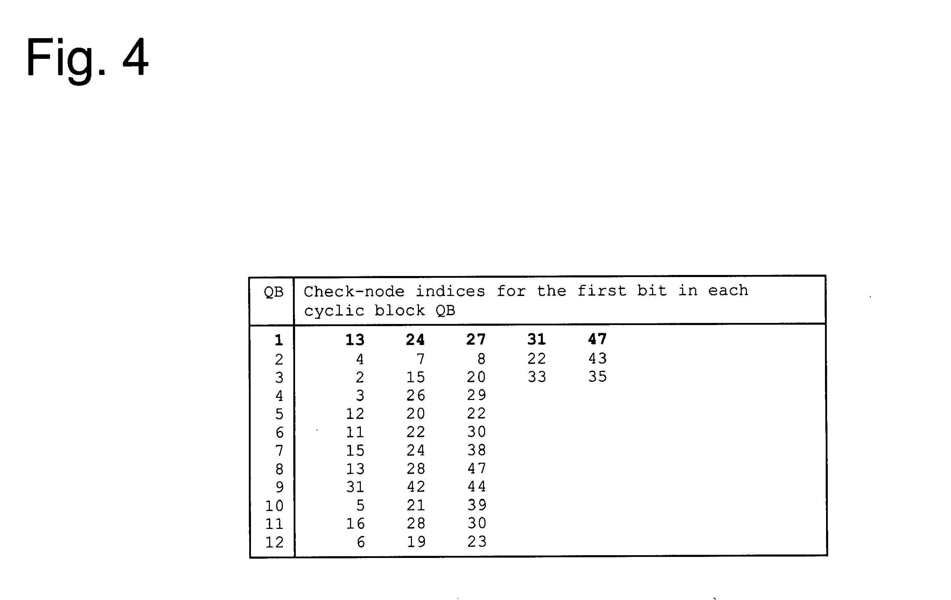

Each LDPC code is fully defined by a table that contains, for the first bit of each cyclic block in the information part, the zero-based indices of the check nodes the bit is connected to. These indices are referred to as "addresses of the parity bit accumulators" in the DVB-S2 standard. For the example LDPC code of Figure 3 this table is shown in Fig. 4.

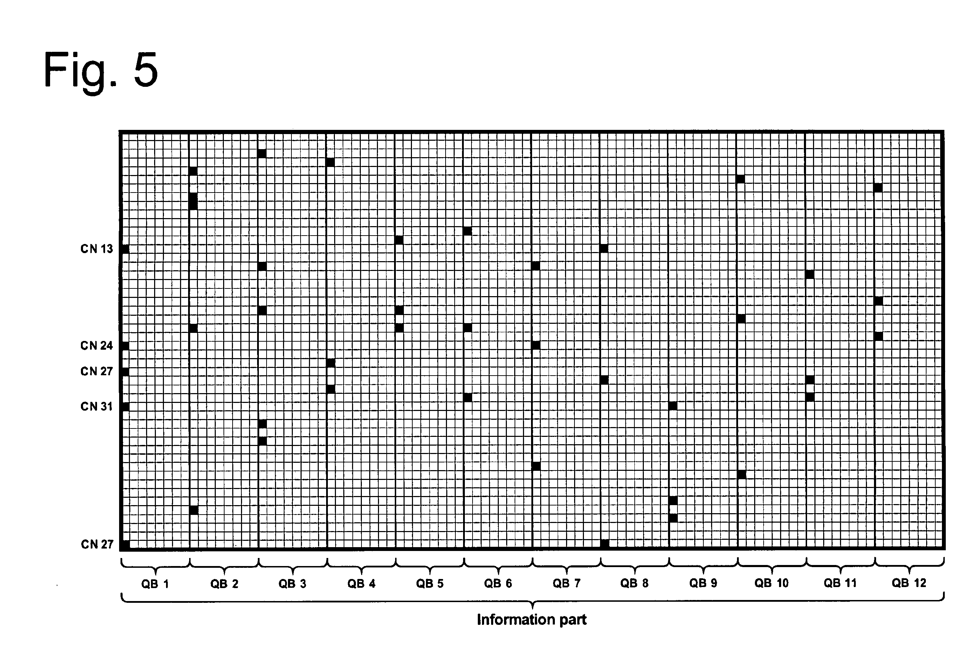

Figure 5 shows the information part of the parity-check matrix for the first bit in each cyclic block of the information part.

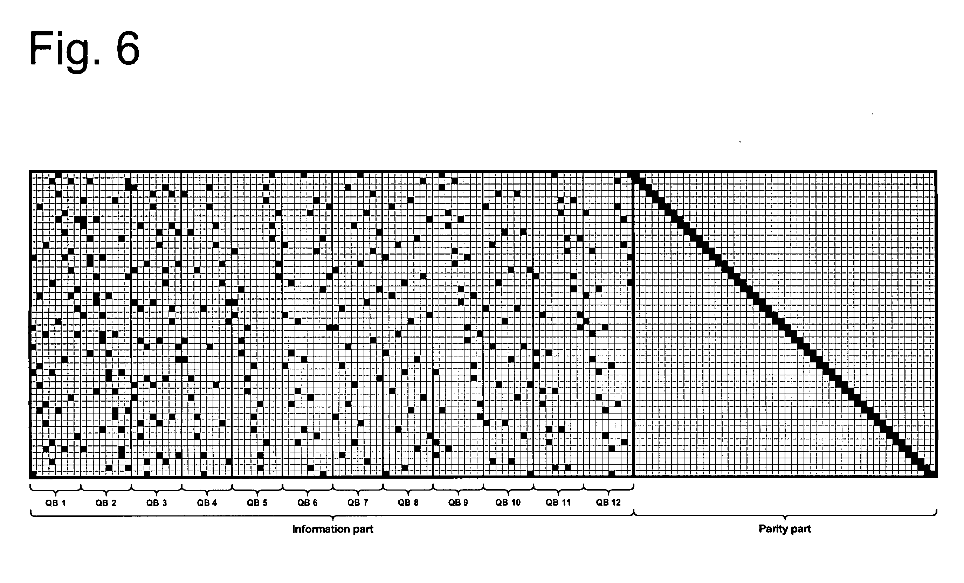

The full parity-check matrix, containing the entries for all information bits, as well as the staircase parity part, is shown in Figure 6.

For the other information bits, the CN indices are computed with the following formula:

$$i_q = (i_0+q*M)\%(Q*M),$$

where q is the bit index (0...Q-1) within a cyclic block; iq is the CN index for bit q; $i_0$ is one of the the CN indices in Table 1; M is the number of cyclic blocks in the parity part, i.e. 6 in this example; Q*M is the number of parity bits, i.e. 48 in this example; and % denotes the modulo operator.

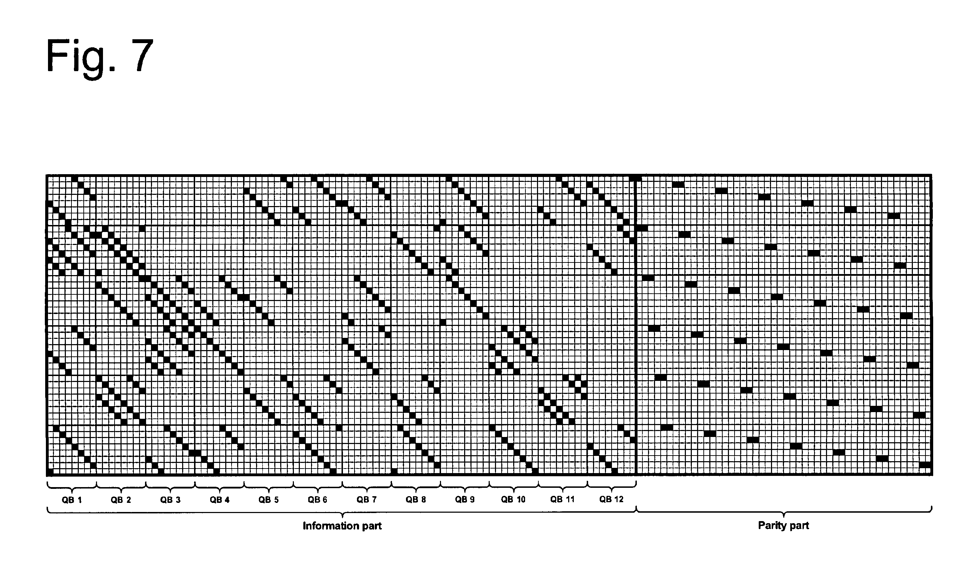

In order to reveal the quasi-cyclic structure of the parity-check matrix in Figure 6, the following permutation is applied to the rows of the matrix, the resulting matrix being shown in Figure 7:

$$j = (i\%M)*Q+floor(i/M)$$

where i and j are the zero-based indices of the non-permuted and the permuted CNs, respectively, and % denotes the modulo operator.

Since the permutation is not applied to the bits, the code definition does not change. The parity part of the resulting parity-check matrix is not quasi cyclic, however. In order to make it quasi cyclic, a special permutation must be applied to the parity bits only.

$$j = [i\%Q]*M+floor(i/Q)$$

where i and j are the zero-based indices of the non-permuted and permuted parity bits respectively.

This permutation does change the code definition and will be referred to as parity permutation or parity interleaving throughout this document. Moreover, this permutation will be regarded as part of the LDPC encoding process from now on.

In the following we introduce the seven LDPC codes that will be specified by the upcoming DVB-NGH standard, which is now under development and is intended for terrestrial reception of digital video services on handheld devices. NGH stands for next-generation handheld.

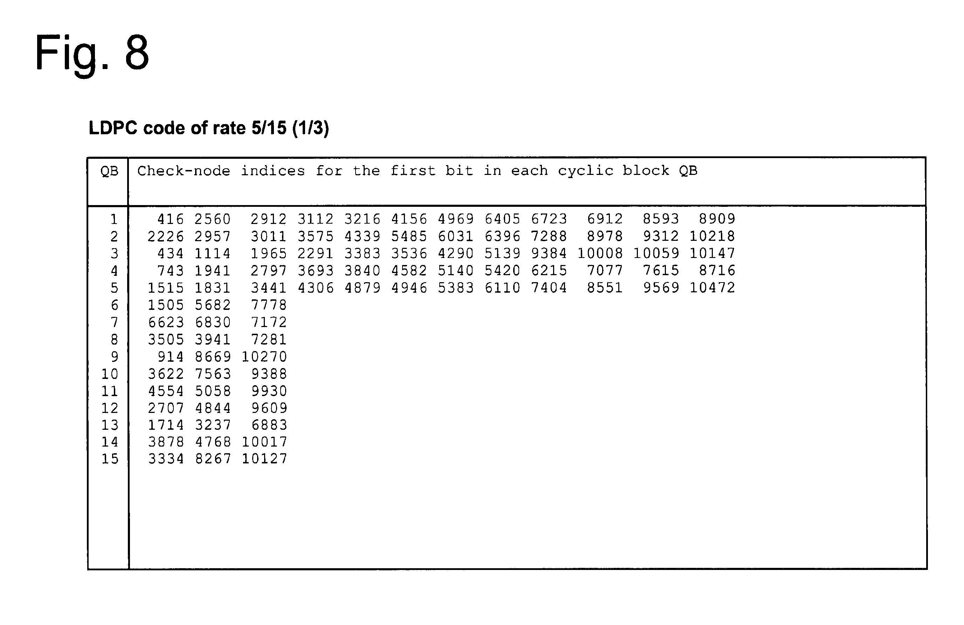

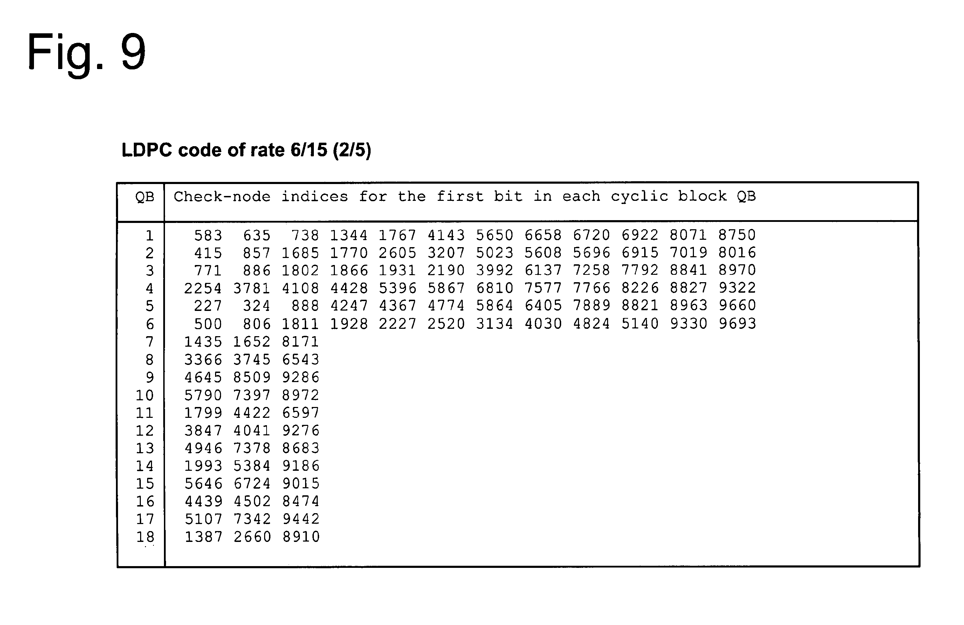

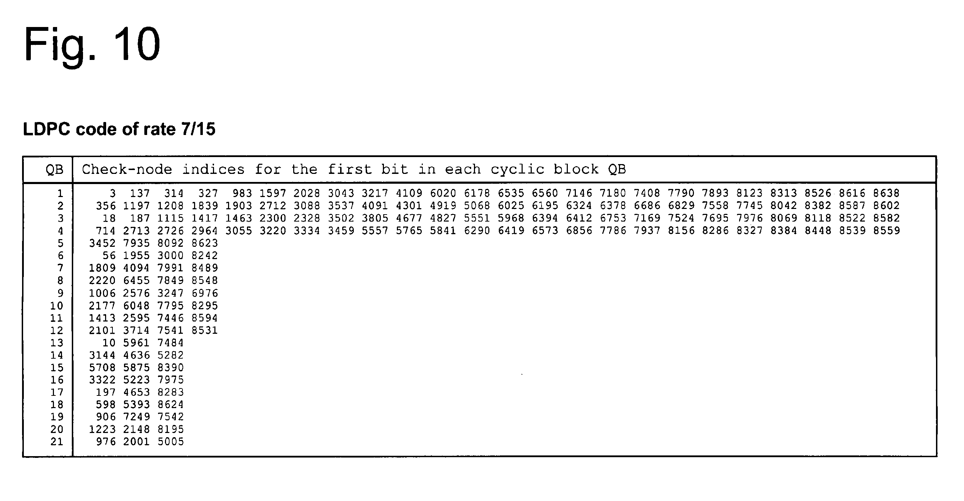

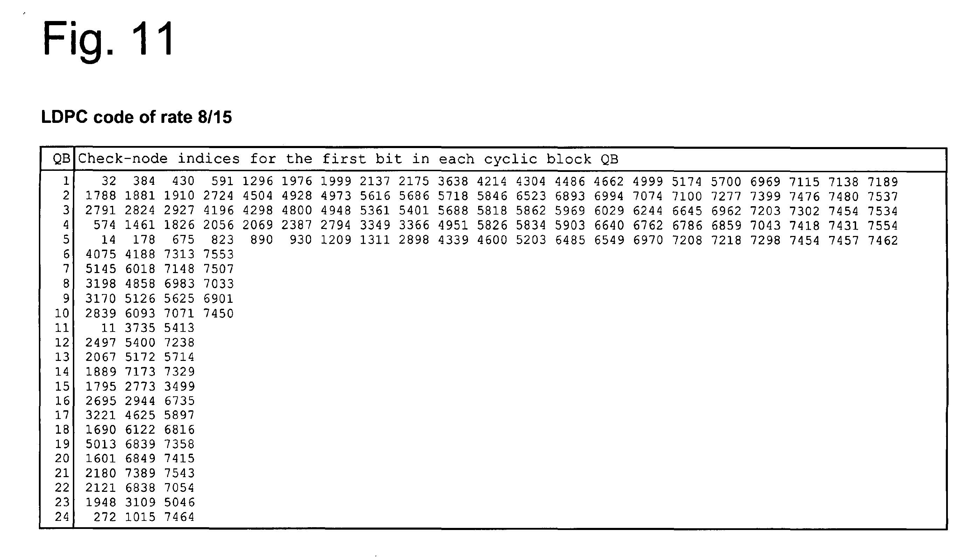

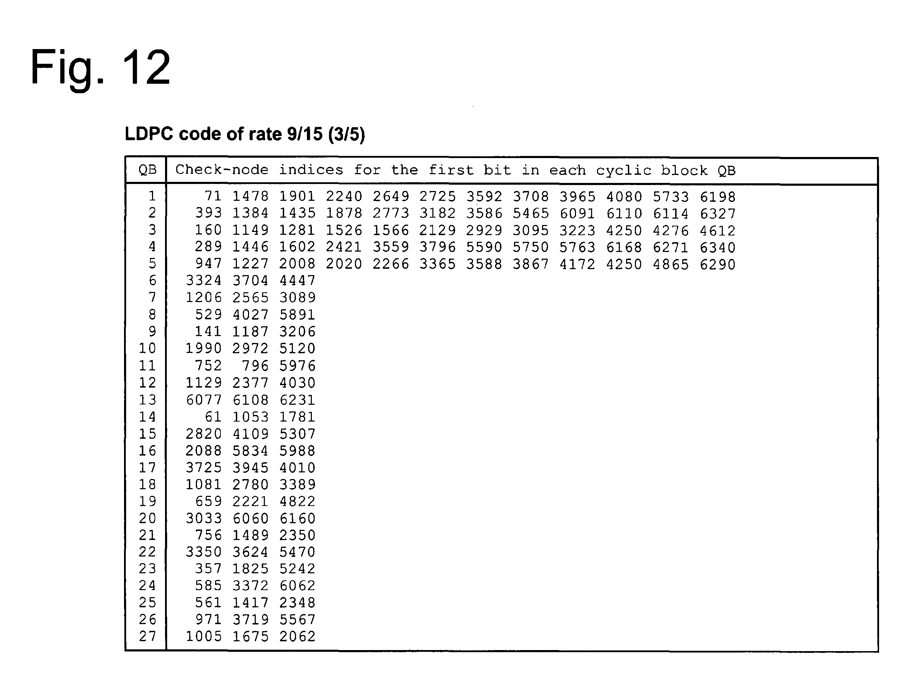

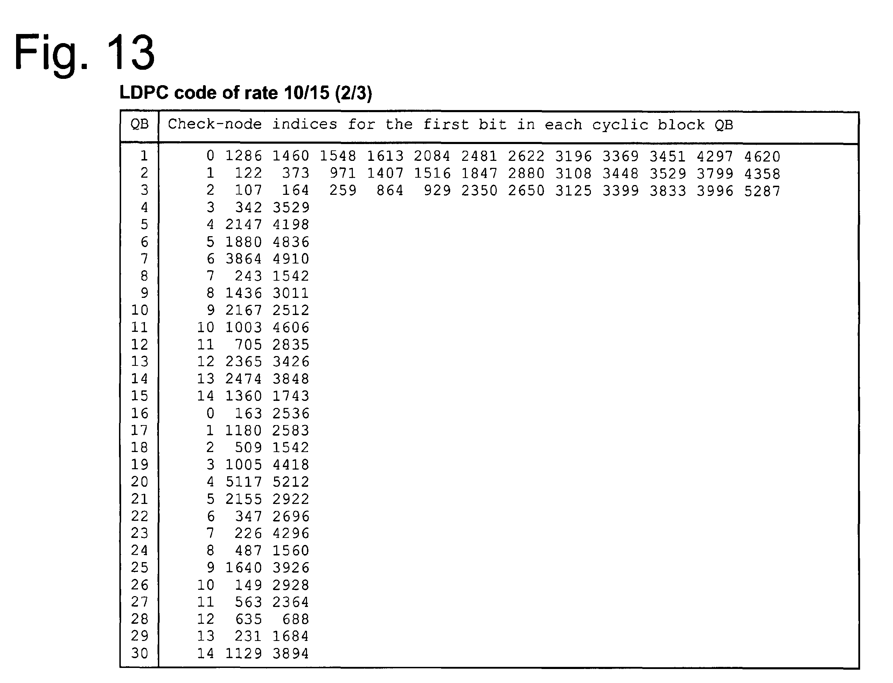

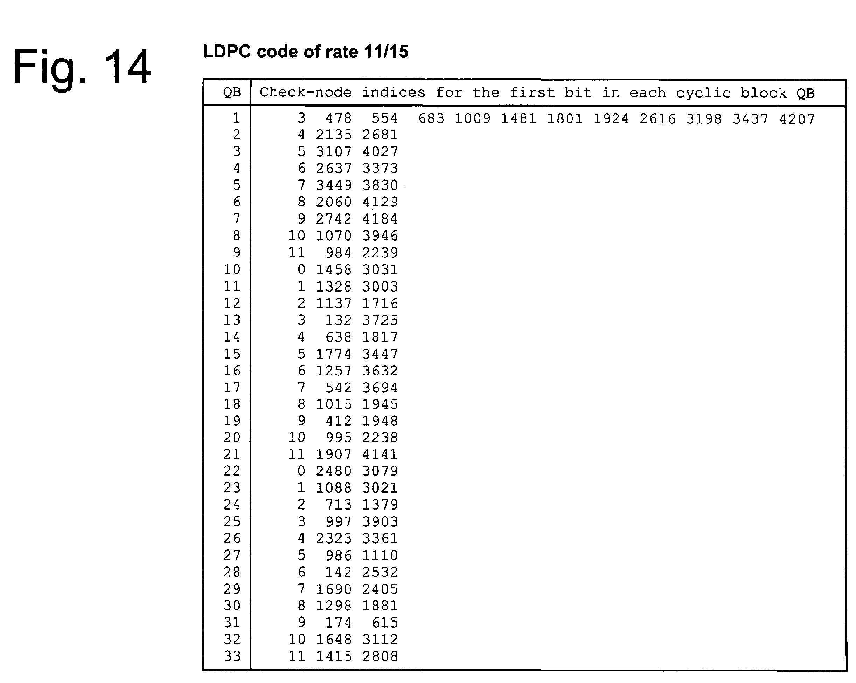

The DVB-NGH standard will specify seven LDPC codes. All codes have a cyclic factor Q=360 and N=45 cyclic blocks per codeword. The codeword length is therefore 16200 bits. The following code rates are defined: 5/15 (1/3), 6/15 (2/5), 7/15, 8/15, 9/15 (3/5), 10/15 (2/3), and 11/15. The definitions of these seven codes are given in Figures 8 to 14, respectively, in the format introduced before.

About spatial multiplexing

The present invention deals specifically with spatial-multiplexing systems with two transmit antennas. In such a system, two complex symbols, denoted by s1 and s2 in Figure 2, are transmitted in the same channel slot. In the case of OFDM modulation a channel slot is represented by an OFDM cell, which is defined as one subcarrier in an OFDM symbol. The two symbols form a spatial-multiplexing (SM) pair.

The two symbols in an SM pair can be transmitted uncoded, i.e. each over its own antenna, or an additional spatial-multiplexing encoding step can be applied, as shown in Figure 2 (SM encoder 125), whereby the two complex QAM symbols s1 and s2 are jointly encoded to produce two complex symbols x1 and x2. The SM encoding typically consists in multiplying the vector [s1 s2] by a 2x2 complex generator matrix G, as shown below.

$$\begin{bmatrix} x_1 \\ x_2 \end{bmatrix} = \underbrace{\begin{bmatrix} g_{11} & g_{12} \\ g_{21} & g_{22} \end{bmatrix}}_{G} \begin{bmatrix} s_1 \\ s_2 \end{bmatrix}$$

QAM mapping

The present invention deals specifically with the case when both complex symbols of an SM pair (s1, s2) have square quadrature amplitude modulation QAM constellations. The two constellations are not necessarily of the same size.

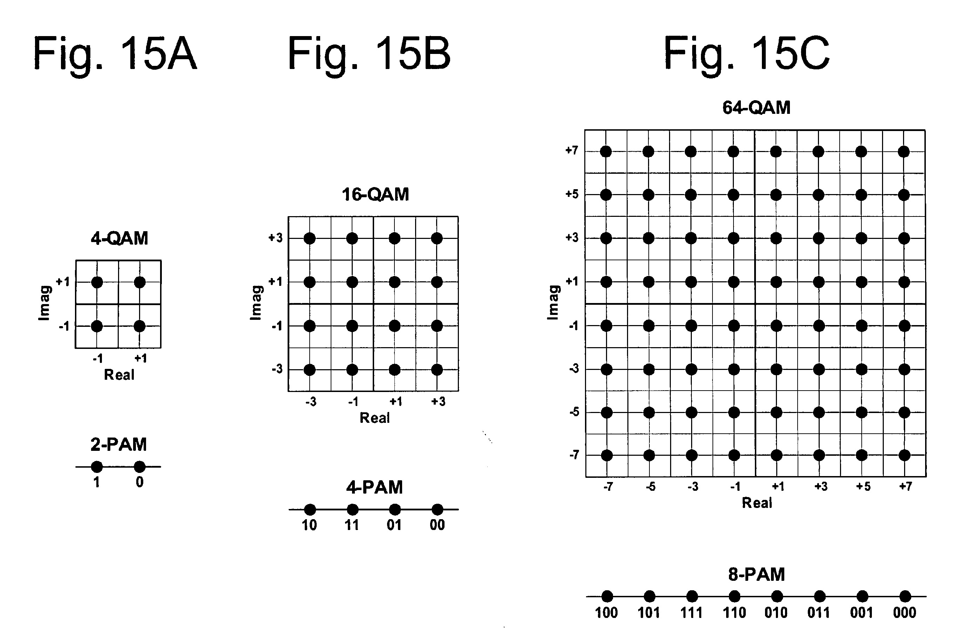

A QAM constellation is obtained by independently modulating the real and the imaginary components using pulse-amplitude modulation (PAM), each point in the constellation corresponding to a unique combination of bits. Figures 15A-15C show the three types of QAM constellations relevant to the present invention: 4-QAM, 16-QAM, and 64-QAM, where the real and imaginary components have the same PAM modulation: 2-PAM, 4-PAM, and 8-PAM, respectively. The present invention also assumes that the PAM mapping has a Gray encoding, as shown in Figures 15A-15C.

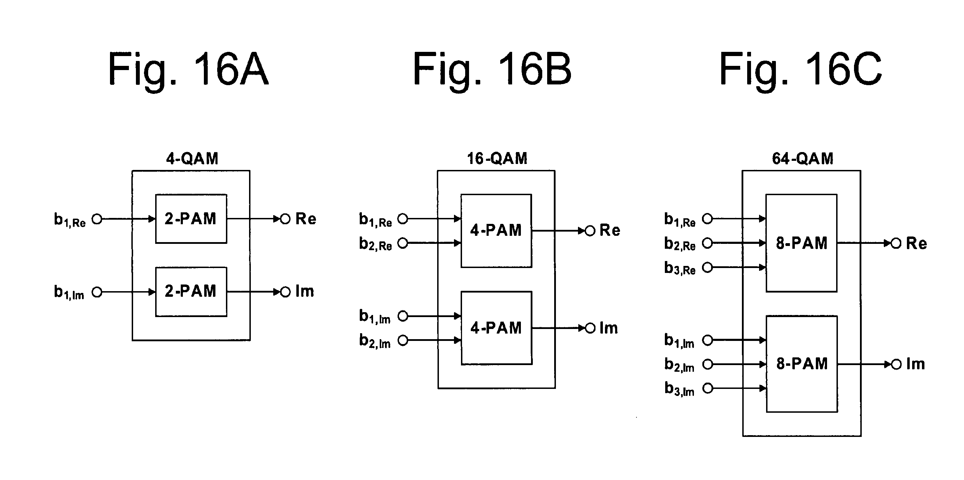

Figures 16A-16C show the corresponding QAM mappers for the three constellations. Each QAM mapper consists of two independent PAM mappers, each encoding the same number of bits.

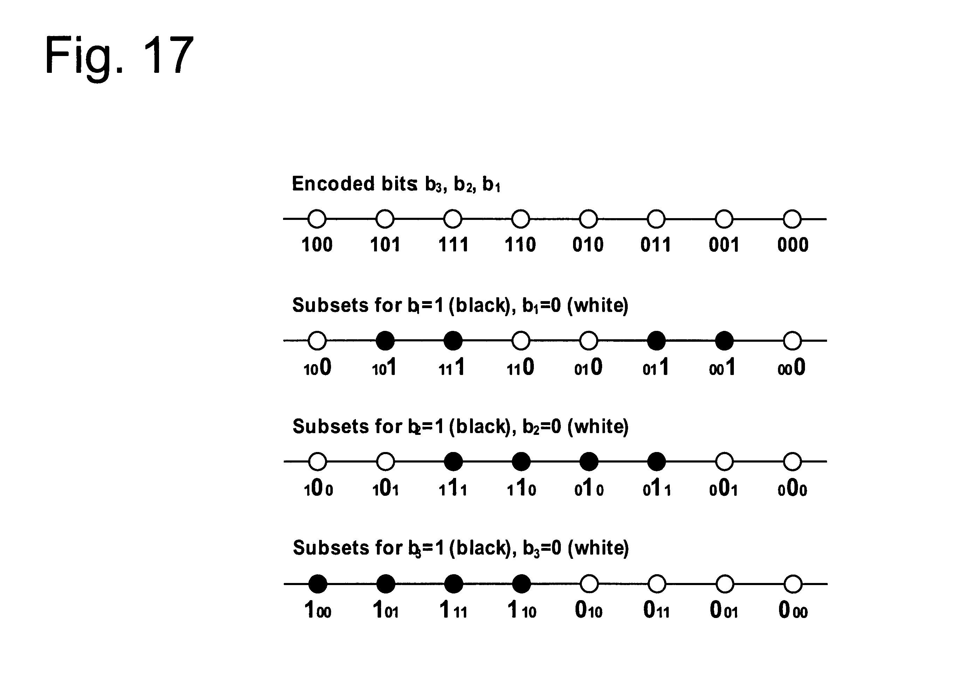

The bits encoded in a PAM symbol have different robustness levels (reliabilities) when the received PAM symbol is demapped in the receiver. This is a well known fact and is illustrated in Figure 17 for an 8-PAM symbol with Gray encoding. The different robustness levels result from the fact that the distance between the two partitions defined by a bit (0 or 1) is different for each of the three bits. The reliability of a bit is proportional to the average distance between the two partitions defined by that bit. In the example shown in Figure 17, bits b1, b2, b3 have increasing reliabilities.

Prior to transmission, the QAM symbols are normalized in power by multiplying them with a scaling factor K. The value of K is: (i) sqrt(2) for QPSK, (ii) sqrt(10) for 16-QAM, and (iii) sqrt(42) for 64-QAM.

From now on we denote the number of bits in the two QAM symbols of an SM pair by B1 and B2 respectively. Since the QAM constellations are square, B1 and B2 are even. In the following, the bits encoded in a QAM constellation will be referred to as a constellation word, and the bits encoded in an SM constellation pair will be referred to as an SM word.

A further aspect relevant to the present invention is that, since a square QAM symbol consists of two identical PAM symbols, the bits encoded in a QAM symbol can be grouped in pairs having the same robustness.

Configurations in DVB-NGH

The spatial-multiplexing profile of the DVB-NGH standard will support the three SM configurations shown in Table 1. For each of the three configurations there are three different ratios of the transmit power applied to the two transmit antennas, namely transmit power ratio 1/1, 1/2, and 1/4.

Table 1: SM configurations used in DVB-NGH

| # bits per channel slot | QAM symbol sizes | Tx power ratio 1/1 | | | Tx power ratio 1/2 | | | Tx power ratio 1/4 | | |
|---|---|---|---|---|---|---|---|---|---|---|
| | | β | θ (deg) | α | β | θ (deg) | α | β | θ (deg) | α |
| 6 | s1: 4-QAM (2 bits) s2: 16-QAM (4 bits) | 1/2 | 45.00 | 0.44 | 1/3 | 0.00 | 0.50 | 1/5 | 0.00 | 0.50 |
| 8 | s1: 16-QAM (4 bits) s2: 16-QAM (4 bits) | 1/2 | 57.76 | 0.50 | 1/3 | 25.00 | 0.50 | 1/5 | 0.00 | 0.50 |
| 10 | s1: 16-QAM (4 bits) s2: 64-QAM (6 bits) | 1/2 | 22.00 | 0.50 | 1/3 | 15.00 | 0.50 | 1/5 | 0.00 | 0.50 |

The generator matrix of the SM encoder has the following generic expression.

$$\mathbf{G} = \begin{bmatrix} 1 & 0 \\ 0 & e^{j\phi(k)} \end{bmatrix} \begin{bmatrix} \sqrt{\beta} & 0 \\ 0 & \sqrt{1-\beta} \end{bmatrix} \begin{bmatrix} \cos\theta & \sin\theta \\ \sin\theta & -\cos\theta \end{bmatrix} \begin{bmatrix} \sqrt{\alpha} & 0 \\ 0 & \sqrt{1-\alpha} \end{bmatrix}$$

The phase φ(k) is a variable phase that changes for each channel slot. The β, θ, and α parameters may change in the final version of the standard. Their concrete values are not relevant to the present invention. What is important is the QAM size on each transmit antenna for the three configurations and the transmit power ratios.

<u>Bit interleaver</u>

Typically, the bits of an LDPC codeword have different importance levels, and the bits of a constellation have different robustness levels. A direct, i.e. non-interteaved, mapping of the LDPC codeword bits to the QAM constellation bits leads to a suboptimal performance. In order to avoid such performance degradation the codeword bits need to be interleaved prior to being mapped onto constellations.

For this purpose, a bit interleaver 122 is used between the LDPC encoder 121 and the QAM constellation mappers 124-1 and 124-2, as illustrated in Figure 2. By carefully designing the interleaver, an optimum association can be achieved between the bits of the LDPC codeword and the bits encoded by the constellation, leading to an improved performance. A typical measure of the performance is the bit-error rate (BER) or the block-error rate (BLER) as a function of the signal-to-noise ratio (SNR).

The different importance levels of the bits of an LDPC codeword result primarily from the fact that not all the bits are involved in the same number of parity checks. The more parity checks (check nodes) a codeword bit (variable node) is involved in, the more important that bit is in the iterative LDPC decoding process. A further reason is the fact that the variable nodes have different connectivities to the cycles in the Tanner graph representation of the LDPC code, so they may still have different importance levels even when they are involved in the same number of parity checks. These aspects are well understood in the art. As a general rule, the importance level of a variable node increases with the number of check nodes it is connected to.

In the particular case of quasi-cyclic LDPC codes, all bits in a cyclic block of Q bits have the same importance since all of them are involved in the same number of parity checks and have the same connectivity to the cycles in the Tanner graph.

In the following, a method for mapping the bits of a quasi-cyclic LDPC codeword to SM words is described. This mapping is performed by bit interleaver 122 in Figure 2. The method is introduced in co-pending application EP 11 006 087.8, which is incorporated herewith in its entirety, for a generic number T of transmit antennas and will be explained in the following for the case relevant to the present invention, i.e. for T=2 transmit antennas. The present invention is specifically optimized for and works in conjunction with such a mapping.

According to co-pending application EP 11 006 087.8, the bits of a quasi-cyclic LDPC codeword are mapped to SM words such that (i) each SM word is made up of bits from (B1+B2)/2 different cyclic blocks of the codeword, (ii) each pair of SM word bits that are encoded in the same QAM symbol and have the same robustness is made up of bits from the same cyclic block, and (iii) constellation words for different transmit antennas are made up of bits from different cyclic blocks.

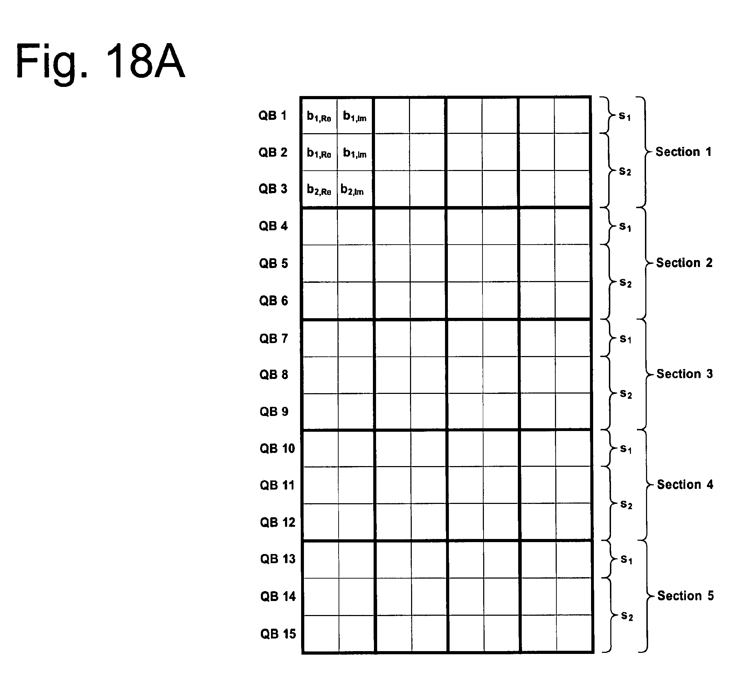

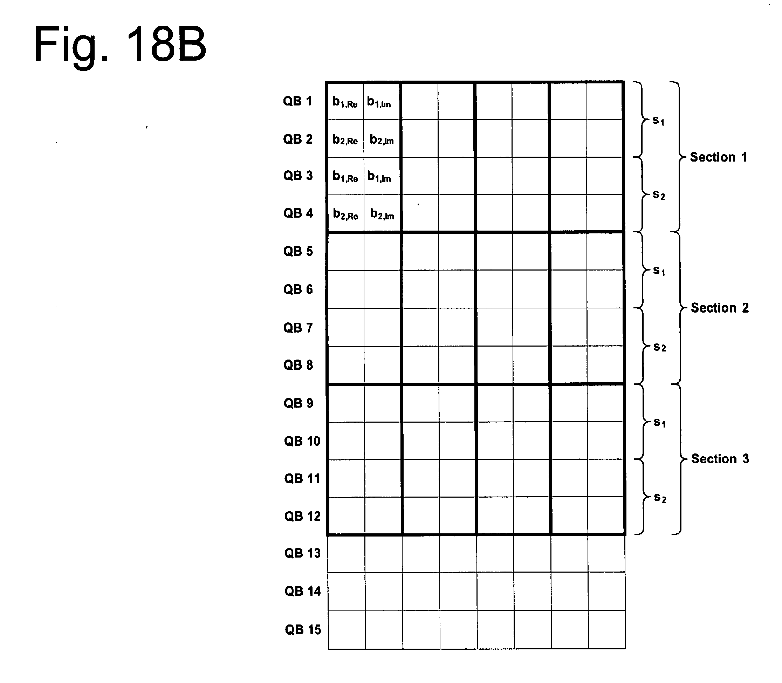

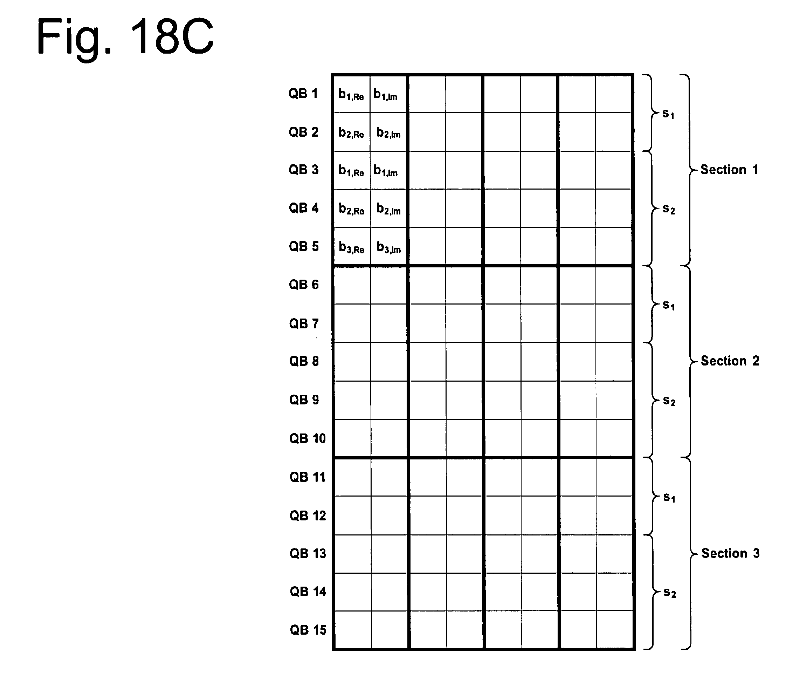

Specifically, the Q·B/2 bits of the B/2 cyclic blocks are mapped to Q/2 spatial-multiplexing blocks. In this case, the B/2 cyclic blocks are referred to as a section. Such a configuration is shown in Figs. 18A to 18C for a spatial-multiplexing system with 2 antennas and a number of bits per spatial-multiplexing block equal to 6, 8, and 10, respectively. The thick borders group bits belonging to the same SM block. In these examples the LDPC parameters are: the cyclic factor Q = 8, and the number of cyclic blocks per codeword N = 15.

For the cases where N is not a multiple of B/2, i.e. B = 8 in the above examples, the codeword cannot be divided into sections of B/2 cyclic blocks each. Instead, there will be a "remainder" of 1 to B/2-1 cyclic blocks. The mapping for these remaining cyclic blocks is not a subject of the present invention. One option is to perform the mapping sequentially.

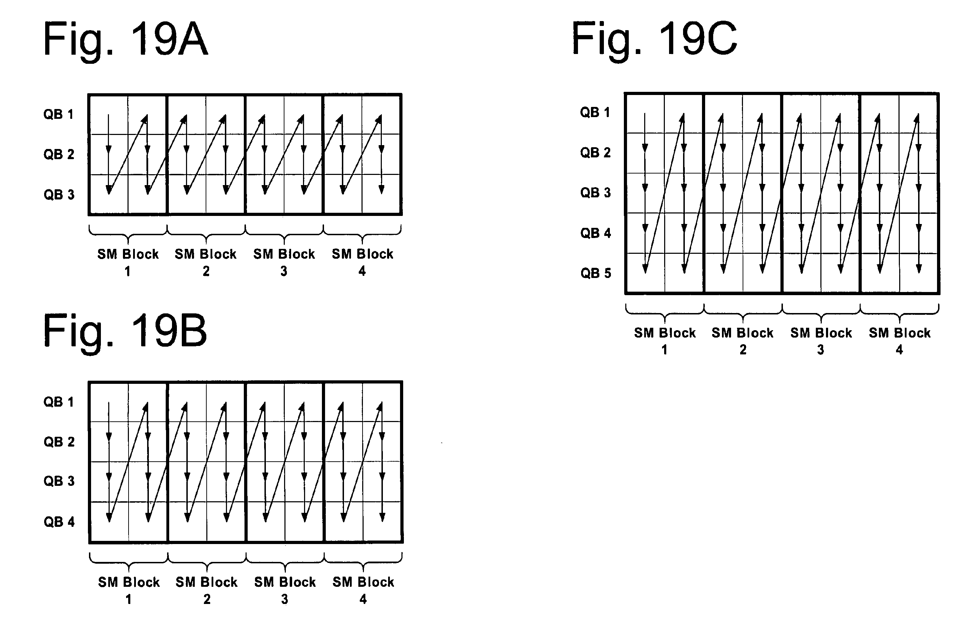

Figures 19A to 19C show a representation of the reordering performed by the bit interleaving for B = 6, 8, and 10, respectively. The number of cyclic blocks per interleaver section is 3, 4, and 5 respectively.

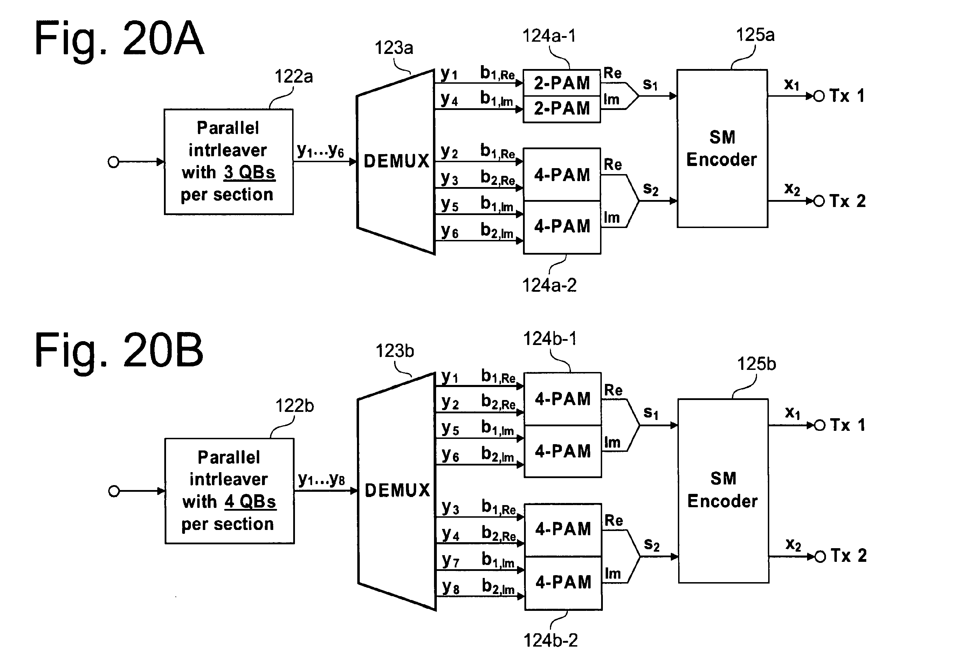

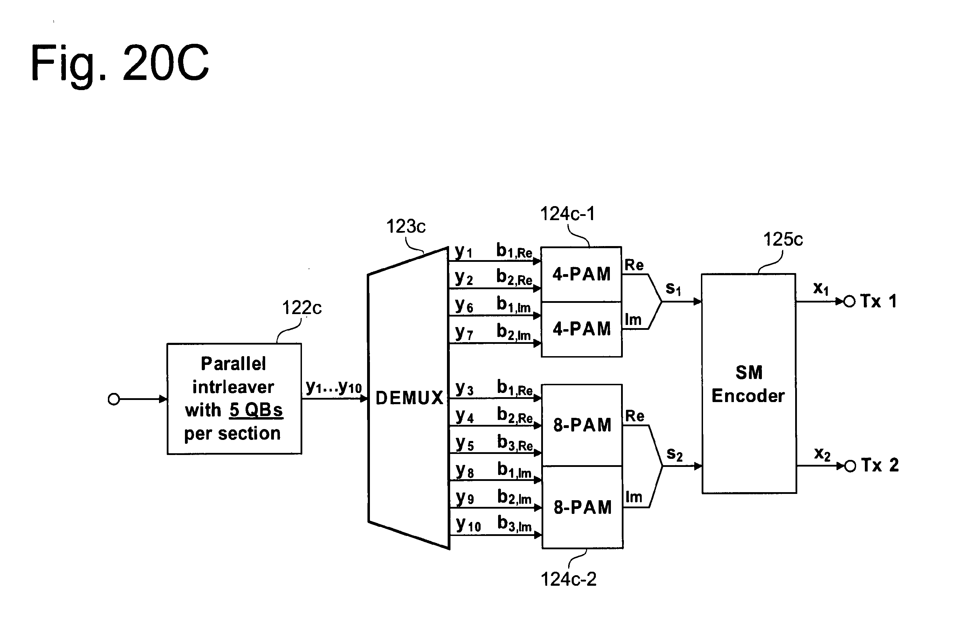

Figures 20A to 20C show specific configurations of the bit interleaver, demultiplexer, and QAM mapper pathway of the BICM encoder of Fig. 2 for B = 6, 8, and 10, respectively. Specifically, the LDPC codeword generated by LDPC encoder 121 in Fig. 2 is fed to bit interleaver 122a, ..., 122c in Figs. 20A to 20C, respectively. The resulting permuted codeword is fed to demultiplexer 123a, ..., 123c in order to map the bits (y1...y4, ..., y1...y10) of the permuted codeword to the constellation words. The bits of each constellation word ($b_{1,Re}$, $b_{1,Im}$, ...) are then mapped to a complex symbol (Re, Im) by means of a pair of PAM mappers (124a-1, 124a-2; ...; 124c-1, 124c-2). The complex symbols may be subjected to a spatial multiplexing by means of an SM encoder (125a, ..., 125c) in order to generate the transmit signals Tx1 and Tx2.

SUMMARY OF THE INVENTION

It is an object of the present invention to improve the performance of communication systems that employ spatial multiplexing and quasi-cyclic LDPC codes.

This is achieved by the features as set forth in the independent claims.

Preferred embodiments are the subject matter of dependent claims.

It is the particular approach of the present invention to map the bits of an LDPC codeword to the constellation word bits such that the importance level of the cyclic blocks and the robustness of the constellation word bits to which they are mapped are matched. The present invention further provides a specific, optimized cyclic-block permutation for each of the three spatial-multiplexing configurations, the three transmission power ratios, and the seven LDPC codes used in the DVB-NGH standard.

According to a first aspect of the present invention, a method for bit interleaving in a communication system with spatial multiplexing over T transmit antennas employing quasi-cyclic low-density parity-check codes, T being an integer greater than 1, is provided. The method comprises the steps of receiving a codeword of the quasi-cyclic low-density parity-check code, the codeword consisting of a sequence of N cyclic blocks, each cyclic block consisting of Q bits, N and Q being positive integers, each cyclic block having an importance level indicated by the number of parity checks its bits are involved in; applying a cyclic block permutation to the codeword so as to obtain a permuted codeword in which the sequence of cyclic blocks is permuted; and mapping the bits of the permuted codeword to a plurality of spatial-multiplexing blocks, each spatial-multiplexing block consisting of B bits partitioned into T constellation words, one for each transmit antenna, B being an integer greater than or equal to 2T, each constellation word indicating one of a plurality of predefined constellation points, the bits of each constellation word being divisible into pairs of bits having the same robustness.

In a particularly preferred embodiment, T=2, N=45, Q=360, and B equals either one of 6, 8, and 10. Moreover, the step of applying the bit permutation is preferably performed by allocating each of the N cyclic blocks to one of a plurality of floor(N/B*2) sections and a residual, each section comprising B/2 cyclic blocks, the residual comprising at most B/2-1 cyclic blocks; and wherein the mapping is performed such that each spatial-multiplexing block is made up of bits from one section only, each constellation word of a spatial-multiplexing block is made up of bits from Bt/2 different cyclic blocks, Bt being the number of bits of the constellation word, and each of the bit pairs of the constellation word is made up of bits from a common one of the Bt/2 different cyclic blocks.

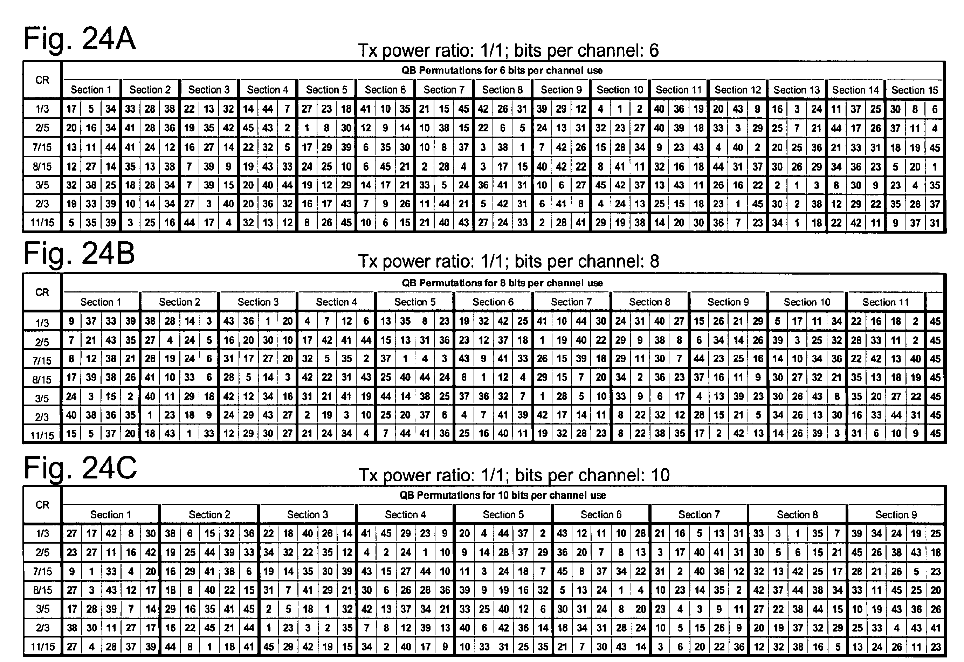

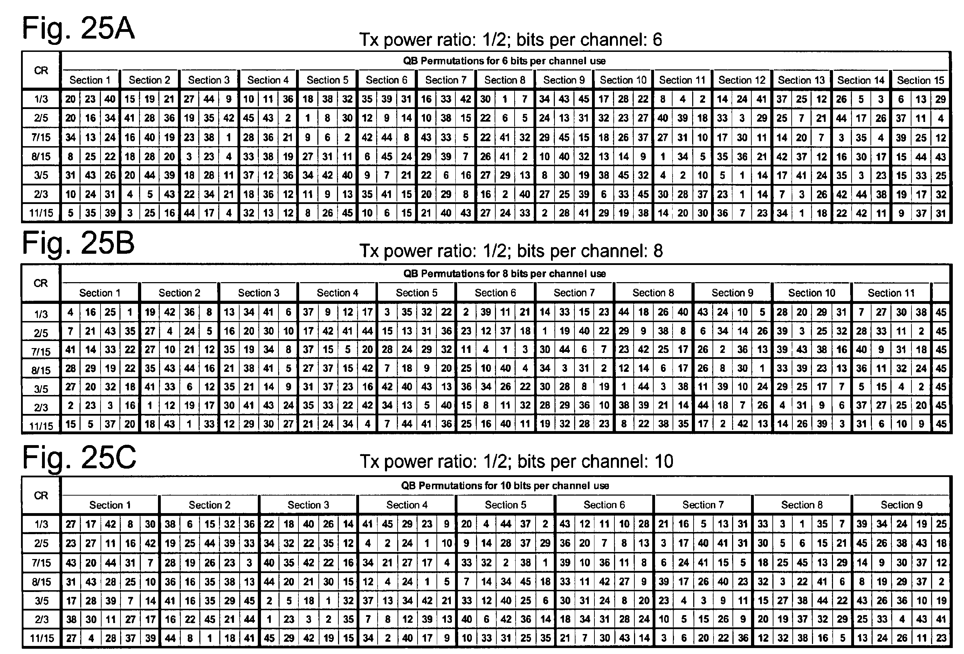

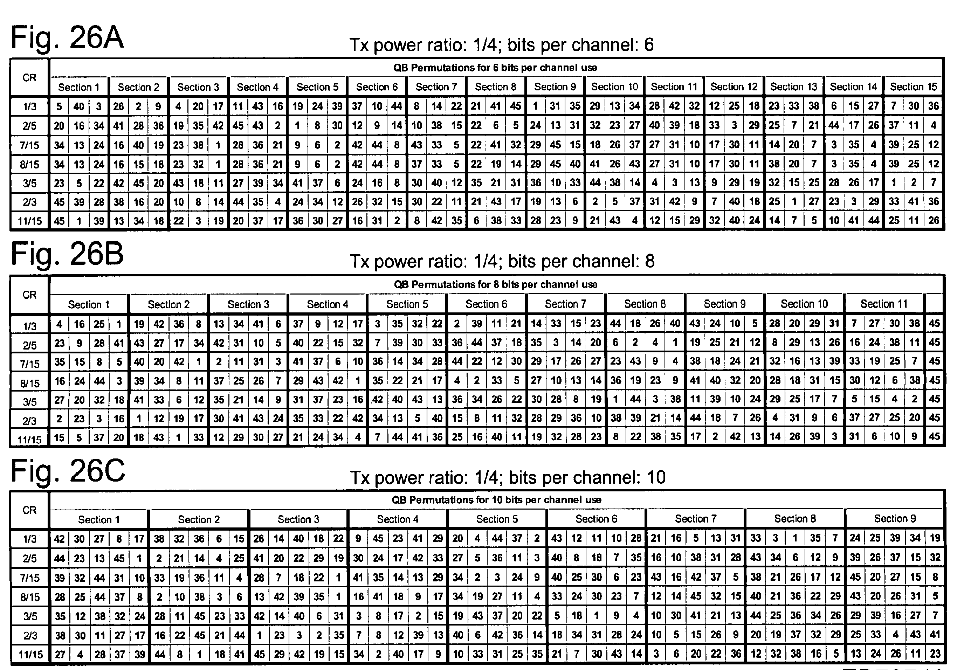

In a preferred embodiment with B=6, wherein the quasi-cyclic low-density parity-check code is a code defined by the DVB-NGH standard with a code rate of either one of 1/3, 2/5, 7/15, 8/15, 3/5, 2/3, and 11/15, and with a transmission power ratio of 1/1, the allocation of cyclic blocks 1, 2, ..., 45 to section 1, section 2, ..., section 15 is performed according to the table shown in Fig. 24A. For a transmission power ratio of 1/2 and 1/4, the cyclic block permutations are defined by the table of Fig. 25A and 26A, respectively. In these cases, the bits of each spatial-multiplexing block are partitioned into a 4-QAM word and a 16-QAM word such that the two bits of the 4-QAM word are made up of bits of the first cyclic block of the respective section, the two bits of the 16-QAM word having the lowest reliability are made up of bits of the second cyclic block of the respective section, and the two bits of the 16-QAM word having the highest reliability are made up of bits of the third cyclic block of the respective section.

In a preferred embodiment with B=8, wherein the quasi-cyclic low-density parity-check code is a code defined by the DVB-NGH standard with a code rate of either one of 1/3, 2/5, 7/15, 8/15, 3/5, 2/3, and 11/15, and with a transmission power ratio of 1/1, the allocation of cyclic blocks 1, 2, ..., 45 to section 1, section 2, ..., section 11 and the residual is performed according to the table shown in Fig. 24B. For a transmission power ratio of 1/2 and 1/4, the cyclic block permutations are defined by the table of Fig. 25B and 26B, respectively. In these cases, the bits of each spatial-multiplexing block are partitioned into a first 16-QAM word and a second 16-QAM word such that the two bits of the first 16-QAM word having the lowest reliability are made up of bits of the first cyclic block of the respective section, and the two bits of the first 16-QAM word having the highest reliability are made up of bits of the second cyclic block of the respective section, the two bits of the second 16-QAM word having the lowest reliability are made up of bits of the third cyclic block of the respective section, and the two bits of the second 16-QAM word having the highest reliability are made up of bits of the fourth cyclic block of the respective section.

In a preferred embodiment with B=10, wherein the quasi-cyclic low-density parity-check code is a code defined by the DVB-NGH standard with a code rate of either one of 1/3, 2/5, 7/15, 8/15, 3/5, 2/3, and 11/15, and with a transmission power ratio of 1/1, the allocation of cyclic blocks 1, 2, ..., 45 to section 1, section 2, ..., section 9 is performed according to the table shown in Fig. 24C. For a transmission power ratio of 1/2 and 1/4, the cyclic block permutations are defined by the table of Fig. 25C and 26C, respectively. In these cases, the bits of each spatial-multiplexing block are partitioned into a 16-QAM word and a 64-QAM word such that the two bits of the 16-QAM word having the lowest reliability are made up of bits of the first cyclic block of the respective section, the two bits of the 16-QAM word having the highest reliability are made up of bits of the second cyclic block of the respective section, the two bits of the 64-QAM word having the lowest reliability are made up of bits of the third cyclic block of the respective section, the two bits of the 64-QAM word having the intermediate reliability are made up of bits of the fourth cyclic block of the respective section, and the two bits of the 64-QAM word having the highest reliability are made up of bits of the fifth cyclic block of the respective section.

According to a second aspect of the present invention, a method for bit de-interleaving in a communication system with spatial multiplexing over T transmit antennas employing quasi-cyclic low-density parity-check codes, T being an integer greater than 1, is provided. The method comprises the steps of receiving a plurality of spatial-multiplexing blocks, each spatial-multiplexing block consisting of B bits partitioned into T constellation words; multiplexing the received plurality of spatial-multiplexing blocks into a bit string; and applying an inverse bit permutation to the bits of the bit string in order to recover a codeword of the quasi-cyclic low-density parity-check code, wherein the inverse bit permutation is adapted for reverting the the cyclic block permutation performed by the bit interleaving method according to the first aspect of the present invention.

According to a third aspect of the present invention, a bit interleaver for a communication system with spatial multiplexing over T transmit antennas employing quasi-cyclic low-density parity-check codes, T being an integer greater than 1, is provided. The bit interleaver comprises a bit permutation unit adapted for receiving a codeword of the quasi-cyclic low-density parity-check code, the codeword consisting of a sequence of N cyclic blocks, each cyclic block consisting of Q bits, N and Q being positive integers, and for applying a cyclic block permutation to the codeword so as to obtain a permuted codeword in which the sequence of cyclic blocks is permuted; and a demultiplexer adapted for mapping the bits of the permuted codeword to a plurality of spatial-multiplexing blocks, each spatial-multiplexing block consisting of B bits partitioned into T constellation words, one for each transmit antenna, B being an integer greater than or equal to 2T, each constellation word indicating one of a plurality of predefined constellation points, the bits of each constellation word being divisible into pairs of bits having the same robustness.

According to a fourth aspect of the present invention, a transmitter for a communication system with spatial multiplexing over T transmit antennas employing quasi-cyclic low-density parity-check codes, T being an integer greater than 1, is provided. The transmitter comprises an encoder for encoding input data by means of a low-density parity check code; a bit interleaver according to the third aspect of the present invention for bit interleaving the bits of a codeword generated by the encoder and for mapping the interleaved bits to a plurality of constellation words; and a plurality of constellation mappers, each for mapping a constellation word of the plurality of constellation words to a complex symbol that is to be transmitted by a corresponding one of a plurality of transmit antennas.

According to a fifth aspect of the present invention, a bit de-interleaver for a communication system with spatial multiplexing over T transmit antennas employing quasi-cyclic low-density parity-check codes, T being an integer greater than 1, is provided. The bit de-interleaver comprises a bit permutation unit adapted for receiving a plurality of spatial-multiplexing blocks, each spatial-multiplexing block consisting of B bits partitioned into T constellation words; for multiplexing the received plurality of spatial-multiplexing blocks into a bit string; and for applying an inverse bit permutation to the bits of the bit string in order to recover a codeword of the quasi-cyclic low-density parity-check code, wherein the inverse bit permutation is adapted for reverting the cyclic block permutation performed by the bit interleaver according to the third aspect of the present invention.

According to a sixth aspect of the present invention, a receiver for a communication system with spatial multiplexing over multiple antennas employing quasi-cyclic low-density parity-check codes, is provided. The transmitter comprises a mulitple-input multiple-output decoder for converting signals from a plurality of receive antennas into a plurality of constellation words, one for each transmit antenna; a mulitplexer for mapping the bits of the constellation words to a bit string; a bit de-interleaver according to the fifth aspect of the present invention for de-interleaving the bits of the bit string in order to recover a codeword of the the low-density parity check code; and a decoder for decoding the recovered codeword.

The above and other objects and features of the present invention will become more apparent from the following description and preferred embodiments given in conjunction with the accompanying drawings, in which:

Fig. 1          is a block diagram of a transmitter-side communication chain involving bit-interleaved coding and modulation with spatial multiplexing over multiple antennas;

Fig. 2          is a block diagram of a bit-interleaved coding and modulation encoder for spatial multiplexing;

Fig. 3          shows the parity check matrix of an exemplary LDPC code with cyclic factor Q=8;

Fig. 4          is a table with an examplary repeat-accumulate LDPC code definition;

Fig. 5          shows the information part of the parity-check matrix for the LDPC code of Fig. 4 for the first bit in each cyclic block of the information part;

Fig. 6          shows the full parity-check matrix of Fig. 5, containing the entries for all information bits, as well as the staircase parity part;

Fig. 7          shows the quasi-cyclic structure of the parity-check matrix of Fig. 6;

Fig. 8          is a table with the definition of the LDPC code of rate 5/15 according to the DVB-NGH standard;

Fig. 9          is a table with the definition of the LDPC code of rate 6/15 according to the DVB-NGH standard;

Fig. 10         is a table with the definition of the LDPC code of rate 7/15 according to the DVB-NGH standard;

Fig. 11         is a table with the definition of the LDPC code of rate 8/15 according to the DVB-NGH standard;

Fig. 12         is a table with the definition of the LDPC code of rate 9/15 according to the DVB-NGH standard;

Fig. 13         is a table with the definition of the LDPC code of rate 10/15 according to the DVB-NGH standard;

Fig. 14         is a table with the definition of the LDPC code of rate 11/15 according to the DVB-NGH standard;

Figs. 15A to 15C    illustrate a 4-QAM constellation, a 16-QAM constellation, and a 64-QAM constellation, respectively;

Figs. 16A to 16C    show a block diagram of a 4-QAM (QPSK) constellation mapper, a 16-QAM constellation mapper, and a 64-QAM constellation mapper, respectively;

Fig. 17         is a schematic illustration of the different robustness levels in a 8-PAM symbol with Gray encoding;

Fig. 18A to 18C    are schematic representations of spatial-multiplexing systems with 2 antennas and a number of bits per SM block equal to 6, 8, and 10, respectively;

Figs. 19A to 19C    are representations of the reordering performed by a bit interleaver for B = 6, 8, and 10, respectively;

Figs. 20A to 20C    show specific configurations of the bit-interleaving coding and modulation encoder of Fig. 2 for B = 6, 8, and 10, respectively;

Fig. 21         shows a structural representation of a bit interleaver according to an embodiment of the present invention;

Fig. 22         shows results of Monte-Carlo simulations with blind and iterative demapping for code rate 8/15 and 8 bits per channel slot;

Figs. 23A to 23C    illustrate a method for finding optimum QB permutations;

Figs. 24A to 24C    show optimized QB permutations according to embodiments of the present invention for B = 6, 8, and 10, respectively, and transmitter power ratio 1/1;

Figs. 25A to 25C    show optimized QB permutations according to embodiments of the present invention for B = 6, 8, and 10, respectively, and transmitter power ratio 1/2;

Figs. 26A to 26C    show optimized QB permutations according to embodiments of the present invention for B = 6, 8, and 10, respectively, and transmitter power ratio 1/4; and

Fig. 27         shows a schematic block diagram of a receiver according to an embodiment of the present invention.

DETAILED DESCRIPTION

The present invention provides a bit interleaver that ensures that (i) the $Bt$ bits of each QAM symbol are mapped to exactly $Bt/2$ cyclic blocks of the quasi-cyclic LDPC codeword in such a way that each of the $Bt/2$ cyclic blocks is associated with bits of the same robustness, and (ii) that the two QAM symbols of a spatial-multiplexing (SM) block are mapped onto different cyclic blocks of the LDPC codeword. In other words, each constellation word is made up of bits from $Bt/2$ different cyclic blocks of the codeword, each pair of constellation word bits that have the same robustness is made up of bits from the same cyclic block, and constellation words for different antennas are made up of bits from different cyclic blocks. Hence, an SM block is made up of bits from $B/2$ cyclic blocks.

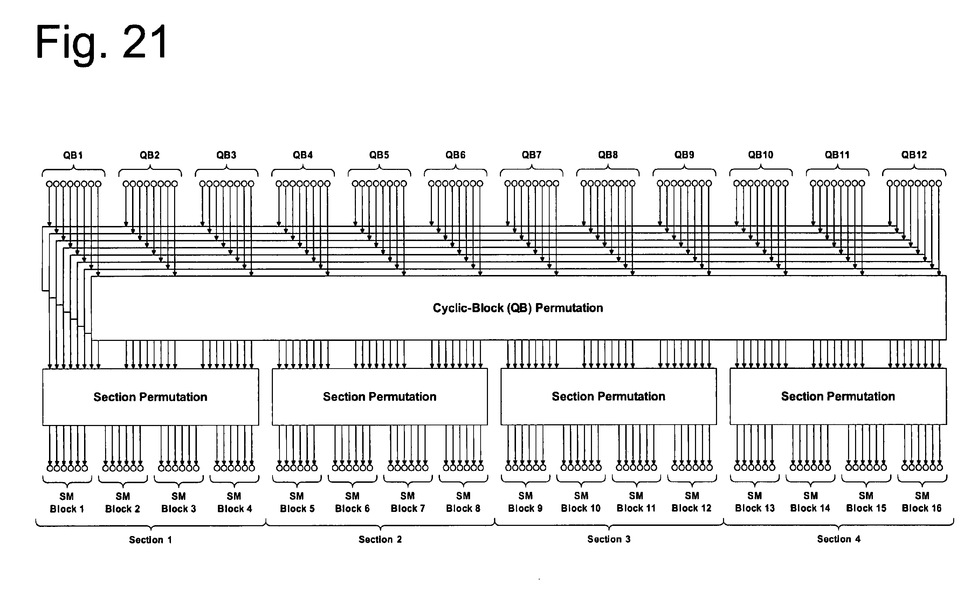

As already mentioned above, different cyclic blocks of a given LDPC code may have different importance levels, depending on the number of check nodes to which they are connected. Therefore, transmission performance may be improved by matching the importance of the cyclic blocks and the robustness of the constellation word bits to which they are mapped. Specifically, the bits of cyclic blocks having the highest importance are mapped to constellation word bits having the highest robustness. Conversely, bits of cyclic blocks having the lowest importance are mapped to constellation word bits having the lowest robustness. Fig. 21 shows a structural representation of a bit interleaver according to an embodiment of the present invention. In the example shown, an LDPC codeword consists of N=12 cyclic blocks QB1, ..., QB12 with Q=8 bits each. The bits of the codeword are mapped to 16 spatial-multiplexing blocks SM Block 1, ..., SM Block 16 having 6 bits each.

The bit interleaving process consists of at least two stages. In a first stage, a cyclic block permutation is applied to the codeword in order to rearrange the sequence of the cyclic blocks, without affecting the sequence of the bits within each cyclic block. In a second stage, the bits of the shuffled cyclic blocks are mapped to the constellation words. The latter step can be implemented by dividing the codeword into a plurality of sections and performing the mapping to the constellation words on a section-by-section basis ("section permutation"). Each section is preferably made up of B/2 cyclic blocks such that the above conditions (i) and (ii) can be met.

The inventor has realized that the performance of the communication system can be improved for a given LDPC code by optimizing the cyclic block permutation, i.e., by choosing a cyclic block permutation that matches constellation bits of different reliabilities with cyclic blocks of different importance levels.

The mapping of cyclic blocks to constellation word bits, however, is not straightforward. Finding optimized cyclic block permutations is a very time-consuming process as no analytical solutions are known so far. The method used for finding the optimized cyclic block permutations disclosed in the present invention consists of the following steps, which are applied for each of the 3x3x7=63 configurations.

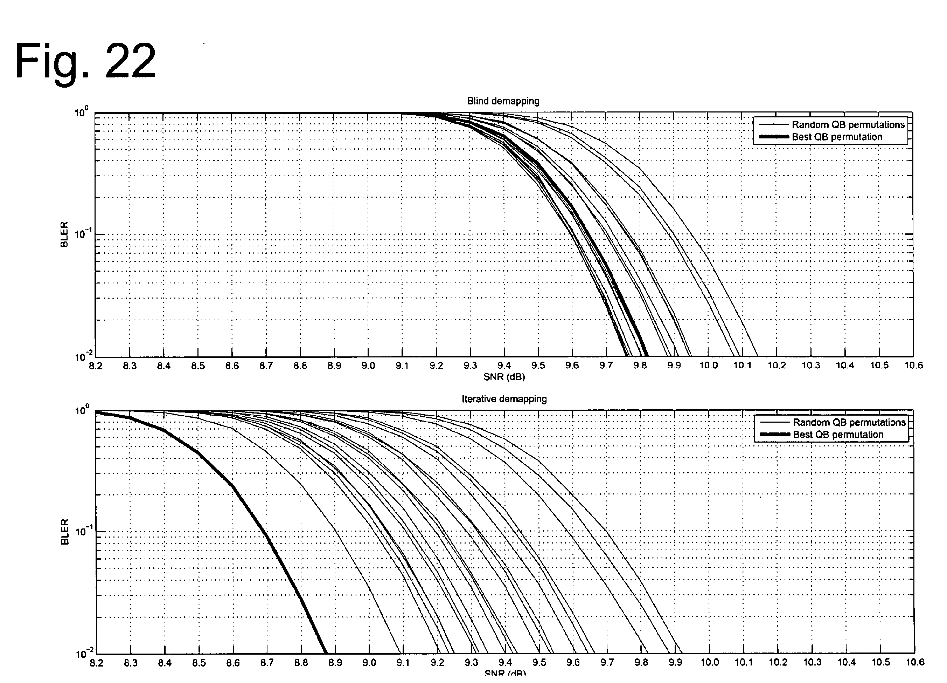

As a preliminary step, several (10...100) unconstrained random QB permutations are generated. For these permutations, Monte-Carlo simulations are performed with blind and iterative demapping in order to generate the corresponding BLER-vs-SNR plots. Figure 22 shows 20 such plots for the code rate 8/15 and B=8 bits per channel slot. The figure also shows in bold lines the optimized permutation found by applying the steps disclosed in the present invention.

The inventor discovered that optimizing the QB permutation for blind demapping results in suboptimal performance with iterative demapping and vice versa. Finding permutations that are good for both types of demapping remains a challenging task.

It is therefore an object of the present invention to present QB permutations that have good performance with both blind and iterative demapping.

From the preliminary step, the SNR range for various QB permutations can be determined. Then, a threshold SNR is set in order to select only permutations that have good performance with blind demapping. Good performance means low SNR. In Figure 22, for example, the threshold SNR could be 9.8 dB. The threshold should not be set too low since that will exclude many permutations that are very good with iterative demapping. Besides, permutations that are heavily optimized for blind demapping perform badly with iterative demapping. Selecting the initial threshold SNR appropriately is a question of experience.

In a first selection step, a large number of unconstrained random QB permutations (e.g. >1,000) is generated. For each permutation, the corresponding BLER curve is determined, e.g. through Monte-Carlo simulations, and only the permutations with a SNR at the target BLER lower than the defined threshold SNR are kept.

For the surviving permutations, the BLER curves with iterative demapping are determined and the best permutation is kept. As an example it is assumed that this permutation is:

06 03 38 04 34 20 02 26 43 25 28 32 12 21 35 41 40 13 37 15 08 30 09 16 07 11 10 42 44 39 24 22 29 19 36 01 23 33 17 18 27 14 31 05

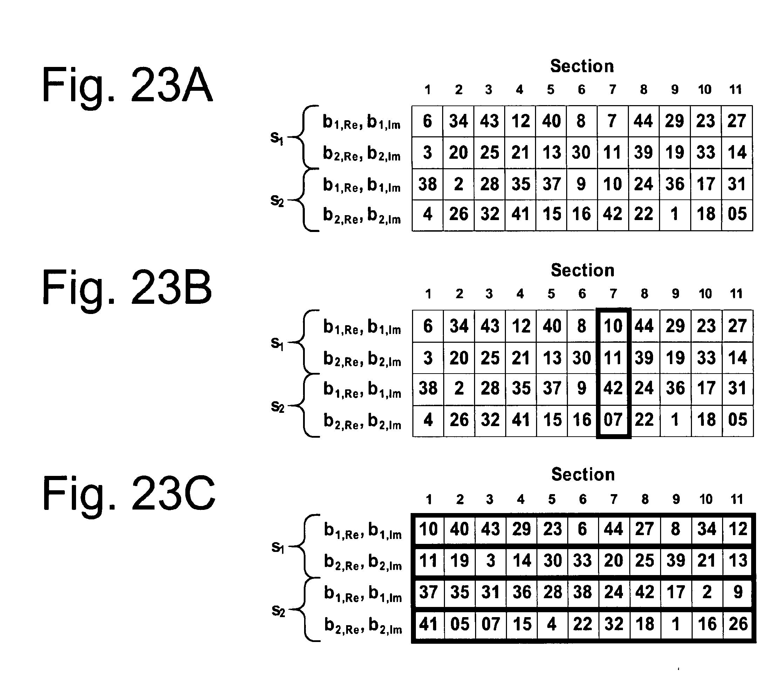

This permutation is also illustrated in Figure 23A, in which the constellation bits and the interleaver sections are shown.

In a second selection step, we generate a medium number (e.g. 100...1,000) of constrained random permutations derived from the permutation returned by the first selection step, and apply the selection criterion from the first selection step. The constrained permutations are derived by applying a random permutation to the cyclic blocks of a single randomly selected section, i.e. to a column of Figure 23A. This is illustrated in Fig. 23B, in which section 7 was selected and permuted so as to obtain [10 11 42 07] instead of the original cyclic-block sequence [07 11 10 42]. Applying such a constraint ensures that the variations in performance are small and concentrated around the already good permutation selected in the first step. In ths manner, better permutations can be found more efficiently than by using a blind unconstrained search.

In a third selection step, a medium number (e.g., 100...1,000) of constrained random permutations are derived from the permutation returned by the second selection step and the selection criterion from the first selection step is applied. The constrained permutations are derived by applying random permutations to the rows of Figure 23B. One random permutation is applied to each row, i.e. robustness level, the length of each permutation being the number of sections. One such example is shown in Figure 23C.

In this third refinement step the variations in performance are rather small and affect the iterative demapping more than the blind demapping. The performance with iterative demapping can therefore be optimized without sacrificing the performance with blind demapping.

Results of the optimization process are illustrated in Figs. 24 to 26 for the three transmitter power ratios, various numbers of bits per channel slot, and different code rates. Each row of Figs. 24A to 24C indicates an optimized QB permutation for each of the predefined DVB-NGH codes with a transmitter power ratio of 1/1 and a code rate of 1/3, 2/5, 7/15, 8/15, 3/5, 2/3, and 11/15, as defined in Figs. 8 to 14, respectively. The second row of Fig. 24A for instance, indicates an optimized QB permutation for the DVD-NGH code with transmitter power ratio 1, B=6 bits per channel slot and code rate 2/5. Specifically, Fig. 24A indicates that the cyclic blocks of each codeword are permuted such that section 1 is made up of cyclic blocks 25, 19, and 40, in the stated order. Section 2 is made up of cyclic blocks 26, 23, and 31, and so on. Figs. 25 and 26 are similar to Fig. 24 but for transmitter power ratio 1/2 and 1/4, respectively.

The mapping of the bits of the permuted codeword to constellation word bits is then performed as indicated in Figs. 18A to 18C. Specifically, in the case of B=6 and a code rate of 2/5, the two bits of the 4-QAM word are made up of bits of the first cyclic block of the respective section, i.e., cyclic block 25 in case of the first section, the two bits of the 16-QAM word having the lowest reliability are made up of bits of the second cyclic block of the respective section, i.e., cyclic block 19 in case of the first section, and the two bits of the 16-QAM word having the highest reliability are made up of bits of the third cyclic block of the respective section, i.e., cyclic block 40 in case of the first section.

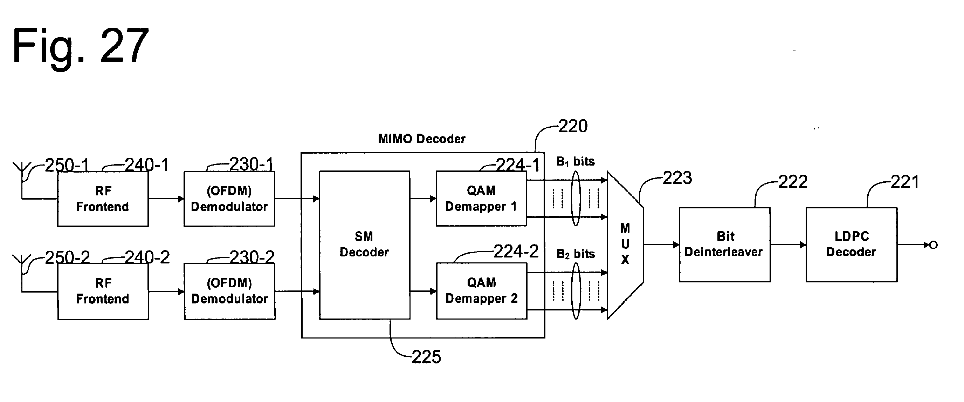

Figure 27 shows a schematic block diagram of a receiver according to an embodiment of the present invention. The receiver mirrors the functionality of the transmitter. A generic receiver has R receive antennas and receives the signal from the T transmit antennas. R and T are not necessarily the same. In Fig. 27, R = T = 2.

The signal from each antenna (250-1, 250-2) is processed by a radio-frequency RF frontend (240-1, 240-2), typically comprising a tuner and a down-converter, and by a demodulator (230-1, 230-2). For each receive antenna (250-1, 250-2), the demodulator (230-1, 230-2) produces for each channel slot one received symbol and T channel fading coefficients. The received symbols and the associated channel coefficients are complex valued. For each channel slot, the R received symbols and the TxR associated channel coefficients are provided as input to the spatial-multiplexing SM decoder (225), which produces T complex symbols at its output. These symbols then undergo QAM constellation demapping (224-1, 224-2), multiplexing (223), bit de-interleaving (222) and LDPC decoding (221), i.e. the exact inverse steps in the transmitter as explained above in conjunction with Figs. 1 and 2.

The combination of SM decoding and QAM constellation demapping is sometimes referred in the art as multiple-input multiple-output (MIMO) decoding. In high-end implementations, a so-called maximum-likelihood decoding is employed, whereby the SM decoding and the QAM constellation demapping are performed jointly in one MIMO decoder block. These aspects are well known in the art.

Although the present invention has been described by referring to specific embodiments illustrated in the enclosed figures, in particular by providing exemplary values for the key parameters N, M, and Q, the present invention is not restricted to any specific combination of such parameters. In fact, the present invention can be applied to any practically relevant combination of values (positive integers) for these parameters, such as those mentioned in the background section in the context of the DVB-T2 standard.

Further, the present invention is not restricted to a particular form for implementing the disclosed methods and devices, both in software or in hardware. Specifically, the invention may be implemented in form of a computer-readable medium having embodied thereon computer-executable instructions that are adapted for allowing a computer, a microprocessor, a microcontroller, and the like, to perform all steps of a method according to the embodiments of the present invention. The invention may also be implemented in form of an application-specific integrated circuit (ASIC) or in form of a field programmable gate array (FPGA).

Summarizing, the present invention relates to bit interleaving and de-interleaving of quasi-cyclic low-density parity-check (QC-LDPC) codes and discloses an interleaving scheme that allows for a matching of the importance level of the cyclic blocks and the robustness of the constellation word bits to which they are mapped. A Monte-Carlo approach is employed for obtaining permutations for re-arranging the sequence of cyclic blocks within a codeword such that the block-error rate is minimized. Specific optimized permutations are provided for the three spatial-multiplexing configurations, three transmission power ratios, and seven LDPC codes used in the DVB-NGH standard.

**Claims**

1. A method for bit interleaving in a communication system with spatial multiplexing over T transmit antennas employing quasi-cyclic low-density parity-check codes, T being an integer greater than 1, the method comprising the steps of:

   receiving a codeword of the quasi-cyclic low-density parity-check code, the codeword consisting of a sequence of N cyclic blocks, each cyclic block consisting of Q bits, N and Q being positive integers;

applying a cyclic block permutation to the codeword so as to obtain a permuted codeword in which the sequence of cyclic blocks is permuted; and

mapping the bits of the permuted codeword to a plurality of spatial-multiplexing blocks, each spatial-multiplexing block consisting of B bits partitioned into T constellation words, one for each transmit antenna, B being an integer greater than or equal to 2T, each constellation word indicating one of a plurality of predefined constellation points, the bits of each constellation word being divisible into pairs of bits having the same robustness.

2. A method according to claim 1, wherein T=2, N=45, Q=360, and B being either one of 6, 8, and 10.

3. A method according to claim 2, wherein the step of applying the cyclic block permutation is performed by allocating each of the N cyclic blocks to one of a plurality of floor(N/B*2) sections and a residual, each section comprising B/2 cyclic blocks, the residual comprising at most B/2-1 cyclic blocks; and

wherein the mapping is performed such that each spatial-multiplexing block is made up of bits from one section only, each constellation word of a spatial-multiplexing block is made up of bits from Bt/2 different cyclic blocks, Bt being the number of bits of the constellation word, and each of the bit pairs of the constellation word is made up of bits from a common one of the Bt/2 different cyclic blocks.

4. A method according to claim 3 with B=6, wherein the quasi-cyclic low-density parity-check code is a code defined by the DVB-NGH standard with a code rate of either one of 1/3, 2/5, 7/15, 8/15, 3/5, 2/3, and 11/15, and with a transmission power ratio of 1/1;

wherein the allocation of cyclic blocks 1, 2, ..., 45 to section 1, section 2, ..., section 15 is performed according to the following table:

| | | Code Rate | | | | | | |
|---|---|---|---|---|---|---|---|---|
| | | 1/3 | 2/5 | 7/15 | 8/15 | 3/5 | 2/3 | 11/15 |
| Section 1 | 1st | 17 | 20 | 13 | 12 | 32 | 19 | 5 |
| | 2nd | 5 | 16 | 11 | 27 | 38 | 33 | 35 |
| | 3rd | 34 | 34 | 44 | 14 | 25 | 39 | 39 |
| Section 2 | 1st | 33 | 41 | 41 | 35 | 18 | 10 | 3 |
| | 2nd | 28 | 28 | 24 | 13 | 28 | 14 | 25 |
| | 3rd | 38 | 36 | 12 | 38 | 34 | 34 | 16 |
| Section 3 | 1st | 22 | 19 | 16 | 7 | 7 | 27 | 44 |
| | 2nd | 13 | 35 | 27 | 39 | 39 | 3 | 17 |
| | 3rd | 32 | 42 | 14 | 9 | 15 | 40 | 4 |
| Section 4 | 1st | 14 | 45 | 22 | 19 | 20 | 20 | 32 |
| | 2nd | 44 | 43 | 32 | 43 | 40 | 36 | 13 |
| | 3rd | 7 | 2 | 5 | 33 | 44 | 32 | 12 |
| Section 5 | 1st | 27 | 1 | 17 | 24 | 19 | 16 | 8 |
| | 2nd | 23 | 8 | 29 | 25 | 12 | 17 | 26 |
| | 3rd | 18 | 30 | 39 | 10 | 29 | 43 | 45 |
| Section 6 | 1st | 41 | 12 | 6 | 6 | 14 | 7 | 10 |
| | 2nd | 10 | 9 | 35 | 45 | 17 | 9 | 6 |
| | 3rd | 35 | 14 | 30 | 21 | 21 | 26 | 15 |
| Section 7 | 1st | 21 | 10 | 10 | 2 | 33 | 11 | 21 |
| | 2nd | 15 | 38 | 8 | 28 | 5 | 44 | 40 |
| | 3rd | 45 | 15 | 37 | 4 | 24 | 21 | 43 |
| Section 8 | 1st | 42 | 22 | 3 | 3 | 36 | 5 | 27 |
| | 2nd | 26 | 6 | 38 | 17 | 41 | 42 | 24 |
| | 3rd | 31 | 5 | 1 | 15 | 31 | 31 | 33 |
| Section 9 | 1st | 39 | 24 | 7 | 40 | 10 | 6 | 2 |
| | 2nd | 29 | 13 | 42 | 42 | 6 | 41 | 28 |

(continued)

| | | Code Rate | | | | | | |
|---|---|---|---|---|---|---|---|---|
| | | 1/3 | 2/5 | 7/15 | 8/15 | 3/5 | 2/3 | 11/15 |
| | 3rd | 12 | 31 | 26 | 22 | 27 | 8 | 41 |
| Section 10 | 1st | 4 | 32 | 15 | 8 | 45 | 4 | 29 |
| | 2nd | 1 | 23 | 28 | 41 | 42 | 24 | 19 |
| | 3rd | 2 | 27 | 34 | 11 | 37 | 13 | 38 |
| Section 11 | 1st | 40 | 40 | 9 | 32 | 13 | 25 | 14 |
| | 2nd | 36 | 39 | 23 | 16 | 43 | 15 | 20 |
| | 3rd | 19 | 18 | 43 | 18 | 11 | 18 | 30 |
| Section 12 | 1st | 20 | 33 | 4 | 44 | 26 | 23 | 36 |
| | 2nd | 43 | 3 | 40 | 31 | 16 | 1 | 7 |
| | 3rd | 9 | 29 | 2 | 37 | 22 | 45 | 23 |
| Section 13 | 1st | 16 | 25 | 20 | 30 | 2 | 30 | 34 |
| | 2nd | 3 | 7 | 25 | 26 | 1 | 2 | 1 |
| | 3rd | 24 | 21 | 36 | 29 | 3 | 38 | 18 |
| Section 14 | 1st | 11 | 44 | 21 | 34 | 8 | 12 | 22 |
| | 2nd | 37 | 17 | 33 | 36 | 30 | 29 | 42 |
| | 3rd | 25 | 26 | 31 | 23 | 9 | 22 | 11 |
| Section 15 | 1st | 30 | 37 | 18 | 5 | 23 | 35 | 9 |
| | 2nd | 8 | 11 | 19 | 20 | 4 | 28 | 37 |
| | 3rd | 6 | 4 | 45 | 1 | 35 | 37 | 31 |

and wherein the bits of each spatial-multiplexing block are partitioned into a 4-QAM word and a 16-QAM word, the two bits of the 4-QAM word being made up of bits of the first cyclic block of the respective section, the two bits of the 16-QAM word having the lowest reliability being made up of bits of the second cyclic block of the respective section, and the two bits of the 16-QAM word having the highest reliability being made up of bits of the third cyclic block of the respective section.

5. A method according to claim 3 with B=8, wherein the quasi-cyclic low-density parity-check code is a code defined by the DVB-NGH standard with a code rate of either one of 1/3, 2/5, 7/15, 8/15, 3/5, 2/3, and 11/15, and with a transmission power ratio of 1/1;
wherein the allocation of cyclic blocks 1, 2, ..., 45 to section 1, section 2, ..., section 11 and the residual is performed according to the following table:

| | | Code Rate | | | | | | |
|---|---|---|---|---|---|---|---|---|
| | | 1/3 | 2/5 | 7/15 | 8/15 | 3/5 | 2/3 | 11/15 |
| Section 1 | 1st | 9 | 7 | 8 | 17 | 24 | 40 | 15 |
| | 2nd | 37 | 21 | 12 | 39 | 3 | 38 | 5 |
| | 3rd | 33 | 43 | 38 | 38 | 15 | 36 | 37 |
| | 4th | 39 | 35 | 21 | 26 | 2 | 35 | 20 |
| Section 2 | 1st | 38 | 27 | 28 | 41 | 40 | 1 | 18 |
| | 2nd | 28 | 4 | 19 | 10 | 11 | 23 | 43 |
| | 3rd | 14 | 24 | 24 | 33 | 29 | 18 | 1 |
| | 4th | 3 | 5 | 6 | 6 | 18 | 9 | 33 |
| Section 3 | 1st | 43 | 16 | 31 | 28 | 42 | 24 | 12 |
| | 2nd | 36 | 20 | 17 | 5 | 12 | 29 | 29 |
| | 3rd | 1 | 30 | 27 | 14 | 34 | 43 | 30 |
| | 4th | 20 | 10 | 20 | 3 | 16 | 27 | 27 |

(continued)

| | | Code Rate | | | | | | |
|---|---|---|---|---|---|---|---|---|
| | | 1/3 | 2/5 | 7/15 | 8/15 | 3/5 | 2/3 | 11/15 |
| Section 4 | 1st | 4 | 17 | 32 | 42 | 31 | 2 | 21 |
| | 2nd | 7 | 42 | 5 | 22 | 21 | 19 | 24 |
| | 3rd | 12 | 41 | 35 | 31 | 41 | 3 | 34 |
| | 4th | 6 | 44 | 2 | 43 | 19 | 10 | 4 |
| Section 5 | 1st | 13 | 15 | 37 | 25 | 44 | 25 | 7 |
| | 2nd | 35 | 13 | 1 | 40 | 14 | 20 | 44 |
| | 3rd | 8 | 31 | 4 | 44 | 38 | 37 | 41 |
| | 4th | 23 | 36 | 3 | 24 | 25 | 6 | 36 |
| Section 6 | 1st | 19 | 23 | 43 | 8 | 37 | 4 | 25 |
| | 2nd | 32 | 12 | 9 | 1 | 36 | 7 | 16 |
| | 3rd | 42 | 37 | 41 | 12 | 32 | 41 | 40 |
| | 4th | 25 | 18 | 33 | 4 | 7 | 39 | 11 |
| Section 7 | 1st | 41 | 1 | 26 | 29 | 1 | 42 | 19 |
| | 2nd | 10 | 19 | 15 | 15 | 28 | 17 | 32 |
| | 3rd | 44 | 40 | 39 | 7 | 5 | 14 | 28 |
| | 4th | 30 | 22 | 18 | 20 | 10 | 11 | 23 |
| Section 8 | 1st | 24 | 29 | 29 | 34 | 33 | 8 | 8 |
| | 2nd | 31 | 9 | 11 | 2 | 9 | 22 | 22 |
| | 3rd | 40 | 38 | 30 | 36 | 6 | 32 | 38 |
| | 4th | 27 | 8 | 7 | 23 | 17 | 12 | 35 |
| Section 9 | 1st | 15 | 6 | 44 | 37 | 4 | 28 | 17 |
| | 2nd | 26 | 34 | 23 | 16 | 13 | 15 | 2 |
| | 3rd | 21 | 14 | 25 | 11 | 39 | 21 | 42 |
| | 4th | 29 | 26 | 16 | 9 | 23 | 5 | 13 |
| Section 10 | 1st | 5 | 39 | 14 | 30 | 30 | 34 | 14 |
| | 2nd | 17 | 3 | 10 | 27 | 26 | 26 | 26 |
| | 3rd | 11 | 25 | 34 | 32 | 43 | 13 | 39 |
| | 4th | 34 | 32 | 36 | 21 | 8 | 30 | 3 |
| Section 11 | 1st | 22 | 28 | 22 | 35 | 35 | 16 | 31 |
| | 2nd | 16 | 33 | 42 | 13 | 20 | 33 | 6 |
| | 3rd | 18 | 11 | 13 | 18 | 27 | 44 | 10 |
| | 4th | 2 | 2 | 40 | 19 | 22 | 31 | 9 |
| Residual | | 45 | 45 | 45 | 45 | 45 | 45 | 45 |

and wherein the bits of each spatial-multiplexing block are partitioned into a first 16-QAM word and a second 16-QAM word, the two bits of the first 16-QAM word having the lowest reliability being made up of bits of the first cyclic block of the respective section, and the two bits of the first 16-QAM word having the highest reliability being made up of bits of the second cyclic block of the respective section, the two bits of the second 16-QAM word having the lowest reliability being made up of bits of the third cyclic block of the respective section, and the two bits of the second 16-QAM word having the highest reliability being made up of bits of the fourth cyclic block of the respective section.

6.  A method according to claim 3 with B=10, wherein the quasi-cyclic low-density parity-check code is a code defined by the DVB-NGH standard with a code rate of either one of 1/3, 2/5, 7/15, 8/15, 3/5, 2/3, and 11/15, and with a transmission power ratio of 1/1;
wherein the allocation of cyclic blocks 1, 2, ..., 45 to section 1, section 2, ..., section 9 is performed according to the following table:

| | | Code Rate | | | | | | |
|---|---|---|---|---|---|---|---|---|
| | | 1/3 | 2/5 | 7/15 | 8/15 | 3/5 | 2/3 | 11/15 |
| Section 1 | 1st | 27 | 23 | 9 | 27 | 17 | 38 | 27 |
| | 2nd | 17 | 27 | 1 | 3 | 28 | 30 | 4 |
| | 3rd | 42 | 11 | 33 | 43 | 39 | 11 | 28 |
| | 4th | 8 | 16 | 4 | 12 | 7 | 27 | 37 |
| | 5th | 30 | 42 | 20 | 17 | 14 | 17 | 39 |
| Section 2 | 1st | 38 | 19 | 16 | 18 | 29 | 16 | 44 |
| | 2nd | 6 | 25 | 29 | 8 | 16 | 22 | 8 |
| | 3rd | 15 | 44 | 41 | 40 | 35 | 45 | 1 |
| | 4th | 32 | 39 | 38 | 22 | 41 | 21 | 18 |
| | 5th | 36 | 33 | 6 | 15 | 45 | 44 | 41 |
| Section 3 | 1st | 22 | 34 | 19 | 31 | 2 | 1 | 45 |
| | 2nd | 18 | 32 | 14 | 7 | 5 | 23 | 29 |
| | 3rd | 40 | 22 | 35 | 41 | 18 | 3 | 42 |
| | 4th | 26 | 35 | 30 | 29 | 1 | 2 | 19 |
| | 5th | 14 | 12 | 39 | 21 | 32 | 35 | 15 |
| Section 4 | 1st | 41 | 4 | 43 | 30 | 42 | 7 | 34 |
| | 2nd | 45 | 2 | 15 | 6 | 13 | 8 | 2 |
| | 3rd | 29 | 24 | 27 | 26 | 37 | 12 | 40 |
| | 4th | 23 | 1 | 44 | 28 | 34 | 39 | 17 |
| | 5th | 9 | 10 | 10 | 36 | 21 | 13 | 9 |
| Section 5 | 1st | 20 | 9 | 11 | 39 | 33 | 40 | 10 |
| | 2nd | 4 | 14 | 3 | 9 | 25 | 6 | 33 |
| | 3rd | 44 | 28 | 24 | 19 | 40 | 42 | 31 |
| | 4th | 37 | 37 | 18 | 16 | 12 | 36 | 25 |
| | 5th | 2 | 29 | 7 | 32 | 6 | 14 | 35 |
| Section 6 | 1st | 43 | 36 | 45 | 5 | 30 | 18 | 21 |
| | 2nd | 12 | 20 | 8 | 13 | 31 | 34 | 7 |
| | 3rd | 11 | 7 | 37 | 24 | 24 | 31 | 30 |
| | 4th | 10 | 8 | 34 | 1 | 8 | 28 | 43 |
| | 5th | 28 | 13 | 22 | 4 | 20 | 24 | 14 |
| Section 7 | 1st | 21 | 3 | 31 | 10 | 23 | 10 | 3 |
| | 2nd | 16 | 17 | 2 | 23 | 4 | 5 | 6 |
| | 3rd | 5 | 40 | 40 | 14 | 3 | 15 | 20 |
| | 4th | 13 | 41 | 36 | 35 | 9 | 26 | 22 |
| | 5th | 31 | 31 | 12 | 2 | 11 | 9 | 36 |
| Section 8 | 1st | 33 | 30 | 32 | 42 | 27 | 20 | 12 |
| | 2nd | 3 | 5 | 13 | 37 | 22 | 19 | 32 |
| | 3rd | 1 | 6 | 42 | 44 | 38 | 37 | 38 |
| | 4th | 35 | 15 | 25 | 38 | 44 | 32 | 16 |
| | 5th | 7 | 21 | 17 | 34 | 15 | 29 | 5 |
| Section 9 | 1st | 39 | 45 | 28 | 33 | 10 | 25 | 13 |
| | 2nd | 34 | 26 | 21 | 11 | 19 | 33 | 24 |
| | 3rd | 24 | 38 | 26 | 45 | 43 | 4 | 26 |
| | 4th | 19 | 43 | 5 | 25 | 36 | 43 | 11 |
| | 5th | 25 | 18 | 23 | 20 | 26 | 41 | 23 |

and wherein the bits of each spatial-multiplexing block are partitioned into a 16-QAM word and a 64-QAM word, the two bits of the 16-QAM word having the lowest reliability being made up of bits of the first cyclic block of the respective section, the two bits of the 16-QAM word having the highest reliability being made up of bits of the second cyclic block of the respective section, the two bits of the 64-QAM word having the lowest reliability being made up of bits of the third cyclic block of the respective section, the two bits of the 64-QAM word having the intermediate reliability being made up of bits of the fourth cyclic block of the respective section, and the two bits of the 64-QAM word having the highest reliability being made up of bits of the fifth cyclic block of the respective section.

**7.** A method according to claim 3 with B=6, wherein the quasi-cyclic low-density parity-check code is a code defined by the DVB-NGH standard with a code rate of either one of 1/3, 2/5, 7/15, 8/15, 3/5, 2/3, and 11/15, and with a transmission power ratio of 1/2;

wherein the allocation of cyclic blocks 1, 2, ..., 45 to section 1, section 2, ..., section 15 is performed according to the following table:

| | | Code Rate | | | | | | |
|---|---|---|---|---|---|---|---|---|
| | | 1/3 | 2/5 | 7/15 | 8/15 | 3/5 | 2/3 | 11/15 |
| Section 1 | 1st | 20 | 20 | 34 | 8 | 31 | 10 | 5 |
| | 2nd | 23 | 16 | 13 | 25 | 43 | 24 | 35 |
| | 3rd | 40 | 34 | 24 | 22 | 26 | 31 | 39 |
| Section 2 | 1st | 15 | 41 | 16 | 18 | 20 | 4 | 3 |
| | 2nd | 19 | 28 | 40 | 28 | 44 | 5 | 25 |
| | 3rd | 21 | 36 | 19 | 20 | 39 | 43 | 16 |
| Section 3 | 1st | 27 | 19 | 23 | 3 | 18 | 22 | 44 |
| | 2nd | 44 | 35 | 38 | 23 | 28 | 34 | 17 |
| | 3rd | 9 | 42 | 1 | 4 | 11 | 21 | 4 |
| Section 4 | 1st | 10 | 45 | 28 | 33 | 37 | 18 | 32 |
| | 2nd | 11 | 43 | 36 | 38 | 12 | 36 | 13 |
| | 3rd | 36 | 2 | 21 | 19 | 36 | 12 | 12 |
| Section 5 | 1st | 18 | 1 | 9 | 27 | 34 | 11 | 8 |
| | 2nd | 38 | 8 | 6 | 31 | 42 | 9 | 26 |
| | 3rd | 32 | 30 | 2 | 11 | 40 | 13 | 45 |
| Section 6 | 1st | 35 | 12 | 42 | 6 | 9 | 35 | 10 |
| | 2nd | 39 | 9 | 44 | 45 | 7 | 41 | 6 |
| | 3rd | 31 | 14 | 8 | 24 | 21 | 15 | 15 |
| Section 7 | 1st | 16 | 10 | 43 | 29 | 22 | 20 | 21 |
| | 2nd | 33 | 38 | 33 | 39 | 6 | 29 | 40 |
| | 3rd | 42 | 15 | 5 | 7 | 16 | 8 | 43 |
| Section 8 | 1st | 30 | 22 | 22 | 26 | 27 | 16 | 27 |
| | 2nd | 1 | 6 | 41 | 41 | 29 | 2 | 24 |
| | 3rd | 7 | 5 | 32 | 2 | 13 | 40 | 33 |
| Section 9 | 1st | 34 | 24 | 29 | 10 | 8 | 27 | 2 |
| | 2nd | 43 | 13 | 45 | 40 | 30 | 25 | 28 |
| | 3rd | 45 | 31 | 15 | 32 | 19 | 39 | 41 |
| Section 10 | 1st | 17 | 32 | 18 | 13 | 38 | 6 | 29 |
| | 2nd | 28 | 23 | 26 | 14 | 45 | 33 | 19 |
| | 3rd | 22 | 27 | 37 | 9 | 32 | 45 | 38 |
| Section 11 | 1st | 8 | 40 | 27 | 1 | 4 | 30 | 14 |
| | 2nd | 4 | 39 | 31 | 34 | 2 | 28 | 20 |
| | 3rd | 2 | 18 | 10 | 5 | 10 | 37 | 30 |

(continued)

| | | Code Rate | | | | | | |
| | | 1/3 | 2/5 | 7/15 | 8/15 | 3/5 | 2/3 | 11/15 |
| --- | --- | --- | --- | --- | --- | --- | --- | --- |
| Section 12 | 1st | 14 | 33 | 17 | 35 | 5 | 23 | 36 |
| | 2nd | 24 | 3 | 30 | 36 | 1 | 1 | 7 |
| | 3rd | 41 | 29 | 11 | 21 | 14 | 14 | 23 |
| Section 13 | 1st | 37 | 25 | 14 | 42 | 17 | 7 | 34 |
| | 2nd | 25 | 7 | 20 | 37 | 41 | 3 | 1 |
| | 3rd | 12 | 21 | 7 | 12 | 24 | 26 | 18 |
| Section 14 | 1st | 26 | 44 | 3 | 16 | 35 | 42 | 22 |
| | 2nd | 5 | 17 | 35 | 30 | 3 | 44 | 42 |
| | 3rd | 3 | 26 | 4 | 17 | 23 | 38 | 11 |
| Section 15 | 1st | 6 | 37 | 39 | 15 | 15 | 19 | 9 |
| | 2nd | 13 | 11 | 25 | 44 | 33 | 17 | 37 |
| | 3rd | 29 | 4 | 12 | 43 | 25 | 32 | 31 |

and wherein the bits of each spatial-multiplexing block are partitioned into a 4-QAM word and a 16-QAM word, the two bits of the 4-QAM word being made up of bits of the first cyclic block of the respective section, the two bits of the 16-QAM word having the lowest reliability being made up of bits of the second cyclic block of the respective section, and the two bits of the 16-QAM word having the highest reliability being made up of bits of the third cyclic block of the respective section.

8. A method according to claim 3 with B=8, wherein the quasi-cyclic low-density parity-check code is a code defined by the DVB-NGH standard with a code rate of either one of 1/3, 2/5, 7/15, 8/15, 3/5, 2/3, and 11/15, and with a transmission power ratio of 1/2;

wherein the allocation of cyclic blocks 1, 2, ..., 45 to section 1, section 2, ..., section 11 and the residual is performed according to the following table:

| | | Code Rate | | | | | | |
| | | 1/3 | 2/5 | 7/15 | 8/15 | 3/5 | 2/3 | 11/15 |
| --- | --- | --- | --- | --- | --- | --- | --- | --- |
| Section 1 | 1st | 4 | 7 | 41 | 28 | 27 | 2 | 15 |
| | 2nd | 16 | 21 | 14 | 29 | 20 | 23 | 5 |
| | 3rd | 25 | 43 | 33 | 19 | 32 | 3 | 37 |
| | 4th | 1 | 35 | 22 | 22 | 18 | 16 | 20 |
| Section 2 | 1st | 19 | 27 | 27 | 35 | 41 | 1 | 18 |
| | 2nd | 42 | 4 | 10 | 43 | 33 | 12 | 43 |
| | 3rd | 36 | 24 | 21 | 44 | 6 | 19 | 1 |
| | 4th | 8 | 5 | 12 | 16 | 12 | 17 | 33 |
| Section 3 | 1st | 13 | 16 | 35 | 21 | 35 | 30 | 12 |
| | 2nd | 34 | 20 | 19 | 38 | 21 | 41 | 29 |
| | 3rd | 41 | 30 | 34 | 41 | 14 | 43 | 30 |
| | 4th | 6 | 10 | 8 | 5 | 9 | 24 | 27 |
| Section 4 | 1st | 37 | 17 | 37 | 27 | 31 | 35 | 21 |
| | 2nd | 9 | 42 | 15 | 37 | 37 | 33 | 24 |
| | 3rd | 12 | 41 | 5 | 15 | 23 | 22 | 34 |
| | 4th | 17 | 44 | 20 | 42 | 16 | 42 | 4 |
| Section 5 | 1st | 3 | 15 | 28 | 7 | 42 | 34 | 7 |
| | 2nd | 35 | 13 | 24 | 18 | 40 | 13 | 44 |
| | 3rd | 32 | 31 | 29 | 9 | 43 | 5 | 41 |

(continued)

| | | Code Rate | | | | | | |
|---|---|---|---|---|---|---|---|---|
| | | 1/3 | 2/5 | 7/15 | 8/15 | 3/5 | 2/3 | 11/15 |
| | 4th | 22 | 36 | 32 | 20 | 13 | 40 | 36 |
| Section 6 | 1st | 2 | 23 | 11 | 25 | 36 | 15 | 25 |
| | 2nd | 39 | 12 | 4 | 10 | 34 | 8 | 16 |
| | 3rd | 11 | 37 | 1 | 40 | 26 | 11 | 40 |
| | 4th | 21 | 18 | 3 | 4 | 22 | 32 | 11 |
| Section 7 | 1st | 14 | 1 | 30 | 34 | 30 | 28 | 19 |
| | 2nd | 33 | 19 | 44 | 3 | 28 | 29 | 32 |
| | 3rd | 15 | 40 | 6 | 31 | 8 | 36 | 28 |
| | 4th | 23 | 22 | 7 | 2 | 19 | 10 | 23 |
| Section 8 | 1st | 44 | 29 | 23 | 12 | 1 | 38 | 8 |
| | 2nd | 18 | 9 | 42 | 14 | 44 | 39 | 22 |
| | 3rd | 26 | 38 | 25 | 6 | 3 | 21 | 38 |
| | 4th | 40 | 8 | 17 | 17 | 38 | 14 | 35 |
| Section 9 | 1st | 43 | 6 | 26 | 26 | 11 | 44 | 17 |
| | 2nd | 24 | 34 | 2 | 8 | 39 | 18 | 2 |
| | 3rd | 10 | 14 | 36 | 30 | 10 | 7 | 42 |
| | 4th | 5 | 26 | 13 | 1 | 24 | 26 | 13 |
| Section 10 | 1st | 28 | 39 | 39 | 33 | 29 | 4 | 14 |
| | 2nd | 20 | 3 | 43 | 39 | 25 | 31 | 26 |
| | 3rd | 29 | 25 | 38 | 23 | 17 | 9 | 39 |
| | 4th | 31 | 32 | 16 | 13 | 7 | 6 | 3 |
| Section 11 | 1st | 7 | 28 | 40 | 36 | 5 | 37 | 31 |
| | 2nd | 27 | 33 | 9 | 11 | 15 | 27 | 6 |
| | 3rd | 30 | 11 | 31 | 32 | 4 | 25 | 10 |
| | 4th | 38 | 2 | 18 | 24 | 2 | 20 | 9 |
| Residual | | 45 | 45 | 45 | 45 | 45 | 45 | 45 |

and wherein the bits of each spatial-multiplexing block are partitioned into a first 16-QAM word and a second 16-QAM word, the two bits of the first 16-QAM word having the lowest reliability being made up of bits of the first cyclic block of the respective section, and the two bits of the first 16-QAM word having the highest reliability being made up of bits of the second cyclic block of the respective section, the two bits of the second 16-QAM word having the lowest reliability being made up of bits of the third cyclic block of the respective section, and the two bits of the second 16-QAM word having the highest reliability being made up of bits of the fourth cyclic block of the respective section.

9. A method according to claim 3 with B=10, wherein the quasi-cyclic low-density parity-check code is a code defined by the DVB-NGH standard with a code rate of either one of 1/3, 2/5, 7/15, 8/15, 3/5, 2/3, and 11/15, and with a transmission power ratio of 1/2;
wherein the allocation of cyclic blocks 1, 2, ..., 45 to section 1, section 2, ..., section 9 is performed according to the following table:

| | | Code Rate | | | | | | |
|---|---|---|---|---|---|---|---|---|
| | | 1/3 | 2/5 | 7/15 | 8/15 | 3/5 | 2/3 | 11/15 |
| Section 1 | 1st | 27 | 23 | 43 | 31 | 17 | 38 | 27 |
| | 2nd | 17 | 27 | 20 | 43 | 28 | 30 | 4 |
| | 3rd | 42 | 11 | 44 | 28 | 39 | 11 | 28 |
| | 4th | 8 | 16 | 31 | 25 | 7 | 27 | 37 |

(continued)

|  |  | Code Rate | | | | | | |
|---|---|---|---|---|---|---|---|---|
|  |  | 1/3 | 2/5 | 7/15 | 8/15 | 3/5 | 2/3 | 11/15 |
|  | 5th | 30 | 42 | 7 | 10 | 14 | 17 | 39 |
| Section 2 | 1st | 38 | 19 | 28 | 36 | 41 | 16 | 44 |
|  | 2nd | 6 | 25 | 19 | 16 | 16 | 22 | 8 |
|  | 3rd | 15 | 44 | 26 | 35 | 35 | 45 | 1 |
|  | 4th | 32 | 39 | 23 | 38 | 29 | 21 | 18 |
|  | 5th | 36 | 33 | 3 | 13 | 45 | 44 | 41 |
| Section 3 | 1st | 22 | 34 | 40 | 44 | 2 | 1 | 45 |
|  | 2nd | 18 | 32 | 35 | 20 | 5 | 23 | 29 |
|  | 3rd | 40 | 22 | 42 | 21 | 18 | 3 | 42 |
|  | 4th | 26 | 35 | 22 | 30 | 1 | 2 | 19 |
|  | 5th | 14 | 12 | 16 | 15 | 32 | 35 | 15 |
| Section 4 | 1st | 41 | 4 | 34 | 12 | 37 | 7 | 34 |
|  | 2nd | 45 | 2 | 21 | 4 | 13 | 8 | 2 |
|  | 3rd | 29 | 24 | 27 | 24 | 34 | 12 | 40 |
|  | 4th | 23 | 1 | 17 | 1 | 42 | 39 | 17 |
|  | 5th | 9 | 10 | 4 | 5 | 21 | 13 | 9 |
| Section 5 | 1st | 20 | 9 | 33 | 7 | 33 | 40 | 10 |
|  | 2nd | 4 | 14 | 32 | 14 | 12 | 6 | 33 |
|  | 3rd | 44 | 28 | 2 | 34 | 40 | 42 | 31 |
|  | 4th | 37 | 37 | 38 | 45 | 25 | 36 | 25 |
|  | 5th | 2 | 29 | 1 | 18 | 6 | 14 | 35 |
| Section 6 | 1st | 43 | 36 | 39 | 33 | 30 | 18 | 21 |
|  | 2nd | 12 | 20 | 10 | 11 | 31 | 34 | 7 |
|  | 3rd | 11 | 7 | 36 | 42 | 24 | 31 | 30 |
|  | 4th | 10 | 8 | 11 | 27 | 8 | 28 | 43 |
|  | 5th | 28 | 13 | 8 | 9 | 20 | 24 | 14 |
| Section 7 | 1st | 21 | 3 | 6 | 39 | 23 | 10 | 3 |
|  | 2nd | 16 | 17 | 24 | 17 | 4 | 5 | 6 |
|  | 3rd | 5 | 40 | 41 | 26 | 3 | 15 | 20 |
|  | 4th | 13 | 41 | 15 | 40 | 9 | 26 | 22 |
|  | 5th | 31 | 31 | 5 | 23 | 11 | 9 | 36 |
| Section 8 | 1st | 33 | 30 | 18 | 32 | 15 | 20 | 12 |
|  | 2nd | 3 | 5 | 25 | 3 | 27 | 19 | 32 |
|  | 3rd | 1 | 6 | 45 | 22 | 38 | 37 | 38 |
|  | 4th | 35 | 15 | 13 | 41 | 44 | 32 | 16 |
|  | 5th | 7 | 21 | 29 | 6 | 22 | 29 | 5 |
| Section 9 | 1st | 39 | 45 | 14 | 8 | 43 | 25 | 13 |
|  | 2nd | 34 | 26 | 9 | 19 | 26 | 33 | 24 |
|  | 3rd | 24 | 38 | 30 | 29 | 36 | 4 | 26 |
|  | 4th | 19 | 43 | 37 | 37 | 10 | 43 | 11 |
|  | 5th | 25 | 18 | 12 | 2 | 19 | 41 | 23 |

and wherein the bits of each spatial-multiplexing block are partitioned into a 16-QAM word and a 64-QAM word, the two bits of the 16-QAM word having the lowest reliability being made up of bits of the first cyclic block of the respective section, the two bits of the 16-QAM word having the highest reliability being made up of bits of the second cyclic block of the respective section, the two bits of the 64-QAM word having the lowest reliability being made up of bits of the third cyclic block of the respective section, the two bits of the 64-QAM word having the intermediate reliability being made up of bits of the fourth cyclic block of the respective section, and the two bits of the 64-QAM word having the highest reliability being made up of bits of the fifth cyclic block of the respective section.

10. A method according to claim 3 with B=6, wherein the quasi-cyclic low-density parity-check code is a code defined by the DVB-NGH standard with a code rate of either one of 1/3, 2/5, 7/15, 8/15, 3/5, 2/3, and 11/15, and with a transmission power ratio of 1/4;

wherein the allocation of cyclic blocks 1, 2, ..., 45 to section 1, section 2, ..., section 15 is performed according to the following table:

| | | Code Rate | | | | | | |
| | | 1/3 | 2/5 | 7/15 | 8/15 | 3/5 | 2/3 | 11/15 |
|---|---|---|---|---|---|---|---|---|
| Section 1 | 1st | 5 | 20 | 34 | 34 | 23 | 45 | 45 |
| | 2nd | 40 | 16 | 13 | 13 | 5 | 39 | 1 |
| | 3rd | 3 | 34 | 24 | 24 | 22 | 28 | 39 |
| Section 2 | 1st | 26 | 41 | 16 | 16 | 42 | 38 | 13 |
| | 2nd | 2 | 28 | 40 | 15 | 45 | 16 | 34 |
| | 3rd | 9 | 36 | 19 | 18 | 20 | 20 | 18 |
| Section 3 | 1st | 4 | 19 | 23 | 23 | 43 | 10 | 22 |
| | 2nd | 20 | 35 | 38 | 32 | 18 | 8 | 3 |
| | 3rd | 17 | 42 | 1 | 1 | 11 | 14 | 19 |
| Section 4 | 1st | 11 | 45 | 28 | 28 | 27 | 44 | 20 |
| | 2nd | 43 | 43 | 36 | 36 | 39 | 35 | 37 |
| | 3rd | 16 | 2 | 21 | 21 | 34 | 4 | 17 |
| Section 5 | 1st | 19 | 1 | 9 | 9 | 41 | 24 | 36 |
| | 2nd | 24 | 8 | 6 | 6 | 37 | 34 | 30 |
| | 3rd | 39 | 30 | 2 | 2 | 6 | 12 | 27 |
| Section 6 | 1st | 37 | 12 | 42 | 42 | 24 | 26 | 16 |
| | 2nd | 10 | 9 | 44 | 44 | 16 | 32 | 31 |
| | 3rd | 44 | 14 | 8 | 8 | 8 | 15 | 2 |
| Section 7 | 1st | 8 | 10 | 43 | 37 | 30 | 30 | 8 |
| | 2nd | 14 | 38 | 33 | 33 | 40 | 22 | 42 |
| | 3rd | 22 | 15 | 5 | 5 | 12 | 11 | 35 |
| Section 8 | 1st | 21 | 22 | 22 | 22 | 35 | 21 | 6 |
| | 2nd | 41 | 6 | 41 | 19 | 21 | 43 | 38 |
| | 3rd | 45 | 5 | 32 | 14 | 31 | 17 | 33 |
| Section 9 | 1st | 1 | 24 | 29 | 29 | 36 | 19 | 28 |
| | 2nd | 31 | 13 | 45 | 45 | 10 | 13 | 23 |
| | 3rd | 35 | 31 | 15 | 40 | 33 | 6 | 9 |
| Section 10 | 1st | 29 | 32 | 18 | 41 | 44 | 2 | 21 |
| | 2nd | 13 | 23 | 26 | 26 | 38 | 5 | 43 |
| | 3rd | 34 | 27 | 37 | 43 | 14 | 37 | 4 |
| Section 11 | 1st | 28 | 40 | 27 | 27 | 4 | 31 | 12 |
| | 2nd | 42 | 39 | 31 | 31 | 3 | 42 | 15 |
| | 3rd | 32 | 18 | 10 | 10 | 13 | 9 | 29 |
| Section 12 | 1st | 12 | 33 | 17 | 17 | 9 | 7 | 32 |
| | 2nd | 25 | 3 | 30 | 30 | 29 | 40 | 40 |
| | 3rd | 18 | 29 | 11 | 11 | 19 | 18 | 24 |
| Section 13 | 1st | 23 | 25 | 14 | 38 | 32 | 25 | 14 |
| | 2nd | 33 | 7 | 20 | 20 | 15 | 1 | 7 |

(continued)

|  |  | Code Rate | | | | | | |
|---|---|---|---|---|---|---|---|---|
|  |  | 1/3 | 2/5 | 7/15 | 8/15 | 3/5 | 2/3 | 11/15 |
|  | 3rd | 38 | 21 | 7 | 7 | 25 | 27 | 5 |
| Section 14 | 1st | 6 | 44 | 3 | 3 | 28 | 23 | 10 |
|  | 2nd | 15 | 17 | 35 | 35 | 26 | 3 | 41 |
|  | 3rd | 27 | 26 | 4 | 4 | 17 | 29 | 44 |
| Section 15 | 1st | 7 | 37 | 39 | 39 | 1 | 33 | 25 |
|  | 2nd | 30 | 11 | 25 | 25 | 2 | 41 | 11 |
|  | 3rd | 36 | 4 | 12 | 12 | 7 | 36 | 26 |

and wherein the bits of each spatial-multiplexing block are partitioned into a 4-QAM word and a 16-QAM word, the two bits of the 4-QAM word being made up of bits of the first cyclic block of the respective section, the two bits of the 16-QAM word having the lowest reliability being made up of bits of the second cyclic block of the respective section, and the two bits of the 16-QAM word having the highest reliability being made up of bits of the third cyclic block of the respective section.

11. A method according to claim 3 with B=8, wherein the quasi-cyclic low-density parity-check code is a code defined by the DVB-NGH standard with a code rate of either one of 1/3, 2/5, 7/15, 8/15, 3/5, 2/3, and 11/15, and with a transmission power ratio of 1/4;
wherein the allocation of cyclic blocks 1, 2, ..., 45 to section 1, section 2, ..., section 11 and the residual is performed according to the following table:

|  |  | Code Rate | | | | | | |
|---|---|---|---|---|---|---|---|---|
|  |  | 1/3 | 2/5 | 7/15 | 8/15 | 3/5 | 2/3 | 11/15 |
| Section 1 | 1st | 4 | 23 | 35 | 16 | 27 | 2 | 15 |
|  | 2nd | 16 | 9 | 15 | 24 | 20 | 23 | 5 |
|  | 3rd | 25 | 28 | 8 | 44 | 32 | 3 | 37 |
|  | 4th | 1 | 41 | 5 | 3 | 18 | 16 | 20 |
| Section 2 | 1st | 19 | 43 | 40 | 39 | 41 | 1 | 18 |
|  | 2nd | 42 | 27 | 20 | 34 | 33 | 12 | 43 |
|  | 3rd | 36 | 17 | 42 | 8 | 6 | 19 | 1 |
|  | 4th | 8 | 34 | 1 | 11 | 12 | 17 | 33 |
| Section 3 | 1st | 13 | 42 | 2 | 37 | 35 | 30 | 12 |
|  | 2nd | 34 | 31 | 11 | 25 | 21 | 41 | 29 |
|  | 3rd | 41 | 10 | 31 | 26 | 14 | 43 | 30 |
|  | 4th | 6 | 5 | 3 | 7 | 9 | 24 | 27 |
| Section 4 | 1st | 37 | 40 | 41 | 29 | 31 | 35 | 21 |
|  | 2nd | 9 | 22 | 37 | 43 | 37 | 33 | 24 |
|  | 3rd | 12 | 15 | 6 | 42 | 23 | 22 | 34 |
|  | 4th | 17 | 32 | 10 | 1 | 16 | 42 | 4 |
| Section 5 | 1st | 3 | 7 | 36 | 35 | 42 | 34 | 7 |
|  | 2nd | 35 | 39 | 14 | 22 | 40 | 13 | 44 |
|  | 3rd | 32 | 30 | 34 | 21 | 43 | 5 | 41 |
|  | 4th | 22 | 33 | 28 | 17 | 13 | 40 | 36 |
| Section 6 | 1st | 2 | 36 | 44 | 4 | 36 | 15 | 25 |
|  | 2nd | 39 | 44 | 22 | 2 | 34 | 8 | 16 |
|  | 3rd | 11 | 37 | 12 | 33 | 26 | 11 | 40 |
|  | 4th | 21 | 18 | 30 | 5 | 22 | 32 | 11 |
| Section 7 | 1st | 14 | 35 | 29 | 27 | 30 | 28 | 19 |

(continued)

| | | Code Rate | | | | | | |
|---|---|---|---|---|---|---|---|---|
| | | 1/3 | 2/5 | 7/15 | 8/15 | 3/5 | 2/3 | 11/15 |
| | 2nd | 33 | 3 | 17 | 10 | 28 | 29 | 32 |
| | 3rd | 15 | 14 | 26 | 13 | 8 | 36 | 28 |
| | 4th | 23 | 20 | 27 | 14 | 19 | 10 | 23 |
| Section 8 | 1st | 44 | 6 | 23 | 36 | 1 | 38 | 8 |
| | 2nd | 18 | 2 | 43 | 19 | 44 | 39 | 22 |
| | 3rd | 26 | 4 | 9 | 23 | 3 | 21 | 38 |
| | 4th | 40 | 1 | 4 | 9 | 38 | 14 | 35 |
| Section 9 | 1st | 43 | 19 | 38 | 41 | 11 | 44 | 17 |
| | 2nd | 24 | 25 | 18 | 40 | 39 | 18 | 2 |
| | 3rd | 10 | 21 | 24 | 32 | 10 | 7 | 42 |
| | 4th | 5 | 12 | 21 | 20 | 24 | 26 | 13 |
| Section 10 | 1st | 28 | 8 | 32 | 28 | 29 | 4 | 14 |
| | 2nd | 20 | 29 | 16 | 18 | 25 | 31 | 26 |
| | 3rd | 29 | 13 | 13 | 31 | 17 | 9 | 39 |
| | 4th | 31 | 26 | 39 | 15 | 7 | 6 | 3 |
| Section 11 | 1st | 7 | 16 | 33 | 30 | 5 | 37 | 31 |
| | 2nd | 27 | 24 | 19 | 12 | 15 | 27 | 6 |
| | 3rd | 30 | 38 | 25 | 6 | 4 | 25 | 10 |
| | 4th | 38 | 11 | 7 | 38 | 2 | 20 | 9 |
| Residual | | 45 | 45 | 45 | 45 | 45 | 45 | 45 |

and wherein the bits of each spatial-multiplexing block are partitioned into a first 16-QAM word and a second 16-QAM word, the two bits of the first 16-QAM word having the lowest reliability being made up of bits of the first cyclic block of the respective section, and the two bits of the first 16-QAM word having the highest reliability being made up of bits of the second cyclic block of the respective section, the two bits of the second 16-QAM word having the lowest reliability being made up of bits of the third cyclic block of the respective section, and the two bits of the second 16-QAM word having the highest reliability being made up of bits of the fourth cyclic block of the respective section.

**12.** A method according to claim 3 with B=10, wherein the quasi-cyclic low-density parity-check code is a code defined by the DVB-NGH standard with a code rate of either one of 1/3, 2/5, 7/15, 8/15, 3/5, 2/3, and 11/15, and with a transmission power ratio of 1/4;
wherein the allocation of cyclic blocks 1, 2, ..., 45 to section 1, section 2, ..., section 9 is performed according to the following table:

| | | Code Rate | | | | | | |
|---|---|---|---|---|---|---|---|---|
| | | 1/3 | 2/5 | 7/15 | 8/15 | 3/5 | 2/3 | 11/15 |
| Section 1 | 1st | 42 | 44 | 39 | 28 | 35 | 38 | 27 |
| | 2nd | 30 | 23 | 32 | 25 | 12 | 30 | 4 |
| | 3rd | 27 | 13 | 44 | 44 | 38 | 11 | 28 |
| | 4th | 8 | 45 | 31 | 37 | 32 | 27 | 37 |
| | 5th | 17 | 1 | 10 | 8 | 24 | 17 | 39 |
| Section 2 | 1st | 38 | 2 | 33 | 2 | 28 | 16 | 44 |
| | 2nd | 32 | 21 | 19 | 10 | 11 | 22 | 8 |
| | 3rd | 36 | 14 | 36 | 38 | 45 | 45 | 1 |
| | 4th | 6 | 4 | 11 | 3 | 23 | 21 | 18 |
| | 5th | 15 | 25 | 4 | 6 | 33 | 44 | 41 |

(continued)

| | | | Code Rate | | | | | |
|---|---|---|---|---|---|---|---|---|
| | | 1/3 | 2/5 | 7/15 | 8/15 | 3/5 | 2/3 | 11/15 |
| Section 3 | 1st | 26 | 41 | 28 | 13 | 42 | 1 | 45 |
| | 2nd | 14 | 20 | 7 | 42 | 14 | 23 | 29 |
| | 3rd | 40 | 22 | 18 | 39 | 40 | 3 | 42 |
| | 4th | 18 | 29 | 22 | 35 | 6 | 2 | 19 |
| | 5th | 22 | 19 | 1 | 1 | 31 | 35 | 15 |
| Section 4 | 1st | 9 | 30 | 41 | 16 | 3 | 7 | 34 |
| | 2nd | 45 | 24 | 35 | 41 | 8 | 8 | 2 |
| | 3rd | 23 | 17 | 14 | 18 | 17 | 12 | 40 |
| | 4th | 41 | 42 | 13 | 9 | 2 | 39 | 17 |
| | 5th | 29 | 33 | 29 | 17 | 15 | 13 | 9 |
| Section 5 | 1st | 20 | 27 | 34 | 34 | 19 | 40 | 10 |
| | 2nd | 4 | 5 | 2 | 19 | 43 | 6 | 33 |
| | 3rd | 44 | 36 | 3 | 27 | 37 | 42 | 31 |
| | 4th | 37 | 11 | 24 | 11 | 20 | 36 | 25 |
| | 5th | 2 | 3 | 9 | 4 | 22 | 14 | 35 |
| Section 6 | 1st | 43 | 40 | 40 | 33 | 5 | 18 | 21 |
| | 2nd | 12 | 8 | 25 | 24 | 18 | 34 | 7 |
| | 3rd | 11 | 18 | 30 | 30 | 1 | 31 | 30 |
| | 4th | 10 | 7 | 6 | 23 | 9 | 28 | 43 |
| | 5th | 28 | 35 | 23 | 7 | 4 | 24 | 14 |
| Section 7 | 1st | 21 | 16 | 43 | 12 | 10 | 10 | 3 |
| | 2nd | 16 | 10 | 16 | 14 | 30 | 5 | 6 |
| | 3rd | 5 | 38 | 42 | 45 | 41 | 15 | 20 |
| | 4th | 13 | 31 | 37 | 32 | 21 | 26 | 22 |
| | 5th | 31 | 28 | 5 | 15 | 13 | 9 | 36 |
| Section 8 | 1st | 33 | 43 | 38 | 40 | 44 | 20 | 12 |
| | 2nd | 3 | 34 | 21 | 21 | 25 | 19 | 32 |
| | 3rd | 1 | 6 | 26 | 36 | 36 | 37 | 38 |
| | 4th | 35 | 12 | 17 | 22 | 34 | 32 | 16 |
| | 5th | 7 | 9 | 12 | 29 | 26 | 29 | 5 |
| Section 9 | 1st | 24 | 39 | 45 | 43 | 29 | 25 | 13 |
| | 2nd | 25 | 26 | 20 | 20 | 39 | 33 | 24 |
| | 3rd | 39 | 37 | 27 | 26 | 16 | 4 | 26 |
| | 4th | 34 | 15 | 15 | 31 | 27 | 43 | 11 |
| | 5th | 19 | 32 | 8 | 5 | 7 | 41 | 23 |

and wherein the bits of each spatial-multiplexing block are partitioned into a 16-QAM word and a 64-QAM word, the two bits of the 16-QAM word having the lowest reliability being made up of bits of the first cyclic block of the respective section, the two bits of the 16-QAM word having the highest reliability being made up of bits of the second cyclic block of the respective section, the two bits of the 64-QAM word having the lowest reliability being made up of bits of the third cyclic block of the respective section, the two bits of the 64-QAM word having the intermediate reliability being made up of bits of the fourth cyclic block of the respective section, and the two bits of the 64-QAM word having the highest reliability being made up of bits of the fifth cyclic block of the respective section.

**13.** A method for bit de-interleaving in a communication system with spatial multiplexing over T transmit antennas employing quasi-cyclic low-density parity-check codes, T being an integer greater than 1, the method comprising the steps of:

receiving a plurality of spatial-multiplexing blocks, each spatial-multiplexing block consisting of B bits partitioned into T=2 constellation words;

multiplexing the received plurality of spatial-multiplexing blocks into a bit string; and

applying an inverse bit permutation to the bits of the bit string in order to recover a codeword of the quasi-cyclic low-density parity-check code,

wherein the inverse bit permutation is adapted for reverting the the cyclic block permutation performed by the bit interleaving method of claims 1 to 12.

14. A bit interleaver for a communication system with spatial multiplexing over T transmit antennas employing quasi-cyclic low-density parity-check codes, T being an integer greater than 1, the bit interleaver comprising

a bit permutation unit adapted for receiving a codeword of the quasi-cyclic low-density parity-check code, the codeword consisting of a sequence of N cyclic blocks, each cyclic block consisting of Q bits, N and Q being positive integers, and for applying a cyclic block permutation to the codeword so as to obtain a permuted codeword in which the sequence of cyclic blocks is permuted; and

a demultiplexer adapted for mapping the bits of the permuted codeword to a plurality of spatial-multiplexing blocks, each spatial-multiplexing block consisting of B bits partitioned into T constellation words, one for each transmit antenna, B being an integer greater than or equal to 2T, each constellation word indicating one of a plurality of predefined constellation points, the bits of each constellation word being divisible into pairs of bits having the same robustness.

15. A transmitter for a communication system with spatial multiplexing over T transmit antennas employing quasi-cyclic low-density parity-check codes, T being an integer greater than 1, the transmitter comprising:

an encoder (121) for encoding input data by means of a low-density parity check code;

a bit interleaver (122, 123) according to claim 14 for bit interleaving the bits of a codeword generated by the encoder (121) and for mapping the interleaved bits to a plurality of constellation words; and

a plurality of constellation mappers (124-1, 124-2), each for mapping a constellation word of the plurality of constellation words to a complex symbol that is to be transmitted by a corresponding one of a plurality of transmit antennas (160-1, 160-2).

16. A bit de-interleaver for a communication system with spatial multiplexing over T=2 transmit antennas employing quasi-cyclic low-density parity-check codes, the bit de-interleaver comprising a bit permutation unit (222, 223) adapted

for receiving a plurality of spatial-multiplexing blocks, each spatial-multiplexing block consisting of B bits partitioned into T=2 constellation words;

for multiplexing the received plurality of spatial-multiplexing blocks into a bit string; and

for applying an inverse bit permutation to the bits of the bit string in order to recover a codeword of the quasi-cyclic low-density parity-check code,

wherein the inverse bit permutation is adapted for reverting the cyclic block permutation performed by the bit interleaver of claim 14.

17. A receiver for a communication system with spatial multiplexing over multiple antennas employing quasi-cyclic low-density parity-check codes, the transmitter comprising:

a mulitple-input multiple-output decoder (220) for converting signals from a plurality of receive antennas (250-1, 250-2) into a plurality of constellation words, one for each transmit antenna (150-1, 150-2);

a mulitplexer for mapping the bits of the constellation words to a bit string;

a bit de-interleaver (222, 223) according to claim 16 for de-interleaving the bits of the bit string in order to recover a codeword of the the low-density parity check code; and

a decoder (221) for decoding the recovered codeword.

# Fig. 1

# Fig. 2

EP 2 560 310 A1

# Fig. 3

QB1  QB2  QB3  QB4  QB5  QB6  QB7  QB8  QB9  QB10  QB11  QB12  QB13  QB14  QB15  QB16  QB17  QB18

Information part

Parity part

EP 2 560 310 A1

# Fig. 4

EP 2 560 310 A1

| QB | Check-node indices for the first bit in each cyclic block QB | | | | |
|----|------|------|------|------|------|
| **1** | **13** | **24** | **27** | **31** | **47** |
| 2 | 4 | 7 | 8 | 22 | 43 |
| 3 | 2 | 15 | 20 | 33 | 35 |
| 4 | 3 | 26 | 29 | | |
| 5 | 12 | 20 | 22 | | |
| 6 | 11 | 22 | 30 | | |
| 7 | 15 | 24 | 38 | | |
| 8 | 13 | 28 | 47 | | |
| 9 | 31 | 42 | 44 | | |
| 10 | 5 | 21 | 39 | | |
| 11 | 16 | 28 | 30 | | |
| 12 | 6 | 19 | 23 | | |

Fig. 5

Fig. 6

# Fig. 7

# Fig. 8

**LDPC code of rate 5/15 (1/3)**

| QB | Check-node indices for the first bit in each cyclic block QB | | | | | | | | | | | |
|---|---|---|---|---|---|---|---|---|---|---|---|---|
| 1 | 416 | 2560 | 2912 | 3112 | 3216 | 4156 | 4969 | 6405 | 6723 | 6912 | 8593 | 8909 |
| 2 | 2226 | 2957 | 3011 | 3575 | 4339 | 5485 | 6031 | 6396 | 7288 | 8978 | 9312 | 10218 |
| 3 | 434 | 1114 | 1965 | 2291 | 3383 | 3536 | 4290 | 5139 | 9384 | 10008 | 10059 | 10147 |
| 4 | 743 | 1941 | 2797 | 3693 | 3840 | 4582 | 5140 | 5420 | 6215 | 7077 | 7615 | 8716 |
| 5 | 1515 | 1831 | 3441 | 4306 | 4879 | 4946 | 5383 | 6110 | 7404 | 8551 | 9569 | 10472 |
| 6 | 1505 | 5682 | 7778 | | | | | | | | | |
| 7 | 6623 | 6830 | 7172 | | | | | | | | | |
| 8 | 3505 | 3941 | 7281 | | | | | | | | | |
| 9 | 914 | 8669 | 10270 | | | | | | | | | |
| 10 | 3622 | 7563 | 9388 | | | | | | | | | |
| 11 | 4554 | 5058 | 9930 | | | | | | | | | |
| 12 | 2707 | 4844 | 9609 | | | | | | | | | |
| 13 | 1714 | 3237 | 6883 | | | | | | | | | |
| 14 | 3878 | 4768 | 10017 | | | | | | | | | |
| 15 | 3334 | 8267 | 10127 | | | | | | | | | |

EP 2 560 310 A1

# Fig. 9

**LDPC code of rate 6/15 (2/5)**

| QB | Check-node indices for the first bit in each cyclic block QB |
|---|---|
| 1 | 583 635 738 1344 1767 4143 5650 6658 6720 6922 8071 8750 |
| 2 | 415 857 1685 1770 2605 3207 5023 5608 5696 6915 7019 8016 |
| 3 | 771 886 1802 1866 1931 2190 3992 6137 7258 7792 8841 8970 |
| 4 | 2254 3781 4108 4428 5396 5867 6810 7577 7766 8226 8827 9322 |
| 5 | 227 324 888 4247 4367 4774 5864 6405 7889 8821 8963 9660 |
| 6 | 500 806 1811 1928 2227 2520 3134 4030 4824 5140 9330 9693 |
| 7 | 1435 1652 8171 |
| 8 | 3366 3745 6543 |
| 9 | 4645 8509 9286 |
| 10 | 5790 7397 8972 |
| 11 | 1799 4422 6597 |
| 12 | 3847 4041 9276 |
| 13 | 4946 7378 8683 |
| 14 | 1993 5384 9186 |
| 15 | 5646 6724 9015 |
| 16 | 4439 4502 8474 |
| 17 | 5107 7342 9442 |
| 18 | 1387 2660 8910 |

EP 2 560 310 A1

# Fig. 10

**LDPC code of rate 7/15**

| QB | Check-node indices for the first bit in each cyclic block QB |
|---|---|
| 1 | 3 137 314 327 983 1597 2028 3043 3217 4109 6020 6178 6535 6560 7146 7180 7408 7790 7893 8123 8313 8526 8616 8638 |
| 2 | 356 1197 1208 1839 1903 2712 3088 3537 4091 4301 4919 5068 6025 6195 6324 6378 6686 6829 7558 7745 8042 8382 8587 8602 |
| 3 | 18 187 1115 1417 1463 2300 2328 3502 3805 4677 4827 5551 5968 6394 6412 6753 7169 7524 7695 7976 8069 8118 8522 8582 |
| 4 | 714 2713 2726 2964 3055 3220 3334 3459 5557 5765 5841 6290 6419 6573 6856 7786 7937 8156 8286 8327 8384 8448 8539 8559 |
| 5 | 3452 7935 8092 8623 |
| 6 | 56 1955 3000 8242 |
| 7 | 1809 4094 7991 8489 |
| 8 | 2220 6455 7849 8548 |
| 9 | 1006 2576 3247 6976 |
| 10 | 2177 6048 7795 8295 |
| 11 | 1413 2595 7446 8594 |
| 12 | 2101 3714 7541 8531 |
| 13 | 10 5961 7484 |
| 14 | 3144 4636 5282 |
| 15 | 5708 5875 8390 |
| 16 | 3322 5223 7975 |
| 17 | 197 4653 8283 |
| 18 | 598 5393 8624 |
| 19 | 906 7249 7542 |
| 20 | 1223 2148 8195 |
| 21 | 976 2001 5005 |

EP 2 560 310 A1

# Fig. 11

**LDPC code of rate 8/15**

| QB | Check-node indices for the first bit in each cyclic block QB |
|----|---|
| 1 | 32 384 430 591 1296 1976 1999 2137 2175 3638 4214 4304 4486 4662 4999 5174 5700 6969 7115 7138 7189 |
| 2 | 1788 1881 1910 2724 4504 4928 4973 5616 5686 5718 5846 6523 6893 6994 7074 7100 7277 7399 7476 7480 7537 |
| 3 | 2791 2824 2927 4196 4298 4800 4948 5361 5401 5688 5818 5862 5969 6029 6244 6645 6962 7203 7302 7454 7534 |
| 4 | 574 1461 1826 2056 2069 2387 2794 3349 3366 4951 5826 5834 5903 6640 6762 6786 6859 7043 7418 7431 7554 |
| 5 | 14 178 675 823 890 930 1209 1311 2898 4339 4600 5203 6485 6549 6970 7208 7218 7298 7454 7457 7462 |
| 6 | 4075 4188 7313 7553 |
| 7 | 5145 6018 7148 7507 |
| 8 | 3198 4858 6983 7033 |
| 9 | 3170 5126 5625 6901 |
| 10 | 2839 6093 7071 7450 |
| 11 | 11 3735 5413 |
| 12 | 2497 5400 7238 |
| 13 | 2067 5172 5714 |
| 14 | 1889 7173 7329 |
| 15 | 1795 2773 3499 |
| 16 | 2695 2944 6735 |
| 17 | 3221 4625 5897 |
| 18 | 1690 6122 6816 |
| 19 | 5013 6839 7358 |
| 20 | 1601 6849 7415 |
| 21 | 2180 7389 7543 |
| 22 | 2121 6838 7054 |
| 23 | 1948 3109 5046 |
| 24 | 272 1015 7464 |

EP 2 560 310 A1

# Fig. 12

**LDPC code of rate 9/15 (3/5)**

| QB | Check-node indices for the first bit in each cyclic block QB |
|---|---|
| 1 | 71 1478 1901 2240 2649 2725 3592 3708 3965 4080 5733 6198 |
| 2 | 393 1384 1435 1878 2773 3182 3586 5465 6091 6110 6114 6327 |
| 3 | 160 1149 1281 1526 1566 2129 2929 3095 3223 4250 4276 4612 |
| 4 | 289 1446 1602 2421 3559 3796 5590 5750 5763 6168 6271 6340 |
| 5 | 947 1227 2008 2020 2266 3365 3588 3867 4172 4250 4865 6290 |
| 6 | 3324 3704 4447 |
| 7 | 1206 2565 3089 |
| 8 | 529 4027 5891 |
| 9 | 141 1187 3206 |
| 10 | 1990 2972 5120 |
| 11 | 752 796 5976 |
| 12 | 1129 2377 4030 |
| 13 | 6077 6108 6231 |
| 14 | 61 1053 1781 |
| 15 | 2820 4109 5307 |
| 16 | 2088 5834 5988 |
| 17 | 3725 3945 4010 |
| 18 | 1081 2780 3389 |
| 19 | 659 2221 4822 |
| 20 | 3033 6060 6160 |
| 21 | 756 1489 2350 |
| 22 | 3350 3624 5470 |
| 23 | 357 1825 5242 |
| 24 | 585 3372 6062 |
| 25 | 561 1417 2348 |
| 26 | 971 3719 5567 |
| 27 | 1005 1675 2062 |

# Fig. 13

**LDPC code of rate 10/15 (2/3)**

| QB | Check-node indices for the first bit in each cyclic block QB | | | | | | | | | | | | |
|----|---|---|---|---|---|---|---|---|---|---|---|---|---|
| 1  | 0  | 1286 | 1460 | 1548 | 1613 | 2084 | 2481 | 2622 | 3196 | 3369 | 3451 | 4297 | 4620 |
| 2  | 1  | 122  | 373  | 971  | 1407 | 1516 | 1847 | 2880 | 3108 | 3448 | 3529 | 3799 | 4358 |
| 3  | 2  | 107  | 164  | 259  | 864  | 929  | 2350 | 2650 | 3125 | 3399 | 3833 | 3996 | 5287 |
| 4  | 3  | 342  | 3529 | | | | | | | | | | |
| 5  | 4  | 2147 | 4198 | | | | | | | | | | |
| 6  | 5  | 1880 | 4836 | | | | | | | | | | |
| 7  | 6  | 3864 | 4910 | | | | | | | | | | |
| 8  | 7  | 243  | 1542 | | | | | | | | | | |
| 9  | 8  | 1436 | 3011 | | | | | | | | | | |
| 10 | 9  | 2167 | 2512 | | | | | | | | | | |
| 11 | 10 | 1003 | 4606 | | | | | | | | | | |
| 12 | 11 | 705  | 2835 | | | | | | | | | | |
| 13 | 12 | 2365 | 3426 | | | | | | | | | | |
| 14 | 13 | 2474 | 3848 | | | | | | | | | | |
| 15 | 14 | 1360 | 1743 | | | | | | | | | | |
| 16 | 0  | 163  | 2536 | | | | | | | | | | |
| 17 | 1  | 1180 | 2583 | | | | | | | | | | |
| 18 | 2  | 509  | 1542 | | | | | | | | | | |
| 19 | 3  | 1005 | 4418 | | | | | | | | | | |
| 20 | 4  | 5117 | 5212 | | | | | | | | | | |
| 21 | 5  | 2155 | 2922 | | | | | | | | | | |
| 22 | 6  | 347  | 2696 | | | | | | | | | | |
| 23 | 7  | 226  | 4296 | | | | | | | | | | |
| 24 | 8  | 487  | 1560 | | | | | | | | | | |
| 25 | 9  | 1640 | 3926 | | | | | | | | | | |
| 26 | 10 | 149  | 2928 | | | | | | | | | | |
| 27 | 11 | 563  | 2364 | | | | | | | | | | |
| 28 | 12 | 635  | 688  | | | | | | | | | | |
| 29 | 13 | 231  | 1684 | | | | | | | | | | |
| 30 | 14 | 1129 | 3894 | | | | | | | | | | |

## Fig. 14

**LDPC code of rate 11/15**

| QB | Check-node indices for the first bit in each cyclic block QB |
|---|---|
| 1 | 3 478 554 683 1009 1481 1801 1924 2616 3198 3437 4207 |
| 2 | 4 2135 2681 |
| 3 | 5 3107 4027 |
| 4 | 6 2637 3373 |
| 5 | 7 3449 3830 |
| 6 | 8 2060 4129 |
| 7 | 9 2742 4184 |
| 8 | 10 1070 3946 |
| 9 | 11 984 2239 |
| 10 | 0 1458 3031 |
| 11 | 1 1328 3003 |
| 12 | 2 1137 1716 |
| 13 | 3 132 3725 |
| 14 | 4 638 1817 |
| 15 | 5 1774 3447 |
| 16 | 6 1257 3632 |
| 17 | 7 542 3694 |
| 18 | 8 1015 1945 |
| 19 | 9 412 1948 |
| 20 | 10 995 2238 |
| 21 | 11 1907 4141 |
| 22 | 0 2480 3079 |
| 23 | 1 1088 3021 |
| 24 | 2 713 1379 |
| 25 | 3 997 3903 |
| 26 | 4 2323 3361 |
| 27 | 5 986 1110 |
| 28 | 6 142 2532 |
| 29 | 7 1690 2405 |
| 30 | 8 1298 1881 |
| 31 | 9 174 615 |
| 32 | 10 1648 3112 |
| 33 | 11 1415 2808 |

EP 2 560 310 A1

# Fig. 15A     Fig. 15B     Fig. 15C

**64-QAM**

**16-QAM**

**4-QAM**

**2-PAM**

1   0

**4-PAM**

10   11   01   00

**8-PAM**

100   101   111   110   010   011   001   000

EP 2 560 310 A1

# Fig. 16A

**4-QAM**

$b_{1,Re}$ ○ → [2-PAM] → ○ Re

$b_{1,Im}$ ○ → [2-PAM] → ○ Im

# Fig. 16B

**16-QAM**

$b_{1,Re}$ ○
$b_{2,Re}$ ○ → [4-PAM] → ○ Re

$b_{1,Im}$ ○
$b_{2,Im}$ ○ → [4-PAM] → ○ Im

# Fig. 16C

**64-QAM**

$b_{1,Re}$ ○
$b_{2,Re}$ ○
$b_{3,Re}$ ○ → [8-PAM] → ○ Re

$b_{1,Im}$ ○
$b_{2,Im}$ ○
$b_{3,Im}$ ○ → [8-PAM] → ○ Im

EP 2 560 310 A1

# Fig. 17

Encoded bits $b_3$, $b_2$, $b_1$

100  101  111  110  010  011  001  000

Subsets for $b_1=1$ (black), $b_1=0$ (white)

$_{10}0$  $_{10}1$  $_{11}1$  $_{11}0$  $_{01}0$  $_{01}1$  $_{00}1$  $_{00}0$

Subsets for $b_2=1$ (black), $b_2=0$ (white)

$_1 0_0$  $_1 0_1$  $_1 1_1$  $_1 1_0$  $_0 1_0$  $_0 1_1$  $_0 0_1$  $_0 0_0$

Subsets for $b_3=1$ (black), $b_3=0$ (white)

$1_{00}$  $1_{01}$  $1_{11}$  $1_{10}$  $0_{10}$  $0_{11}$  $0_{01}$  $0_{00}$

EP 2 560 310 A1

EP 2 560 310 A1

# Fig. 18A

| | | | | | | | | |
|---|---|---|---|---|---|---|---|---|
| QB 1 | $b_{1,Re}$ | $b_{1,Im}$ | | | | | | |
| QB 2 | $b_{1,Re}$ | $b_{1,Im}$ | | | | | | |
| QB 3 | $b_{2,Re}$ | $b_{2,Im}$ | | | | | | |
| QB 4 | | | | | | | | |
| QB 5 | | | | | | | | |
| QB 6 | | | | | | | | |
| QB 7 | | | | | | | | |
| QB 8 | | | | | | | | |
| QB 9 | | | | | | | | |
| QB 10 | | | | | | | | |
| QB 11 | | | | | | | | |
| QB 12 | | | | | | | | |
| QB 13 | | | | | | | | |
| QB 14 | | | | | | | | |
| QB 15 | | | | | | | | |

$s_1$ / $s_2$ — Section 1
$s_1$ / $s_2$ — Section 2
$s_1$ / $s_2$ — Section 3
$s_1$ / $s_2$ — Section 4
$s_1$ / $s_2$ — Section 5

# Fig. 18B

| | | | | | | | | | | |
|---|---|---|---|---|---|---|---|---|---|---|
| QB 1 | $b_{1,Re}$ | $b_{1,Im}$ | | | | | | | | $s_1$ |
| QB 2 | $b_{2,Re}$ | $b_{2,Im}$ | | | | | | | | |
| QB 3 | $b_{1,Re}$ | $b_{1,Im}$ | | | | | | | | $s_2$ |
| QB 4 | $b_{2,Re}$ | $b_{2,Im}$ | | | | | | | | |
| QB 5 | | | | | | | | | | $s_1$ |
| QB 6 | | | | | | | | | | |
| QB 7 | | | | | | | | | | $s_2$ |
| QB 8 | | | | | | | | | | |
| QB 9 | | | | | | | | | | $s_1$ |
| QB 10 | | | | | | | | | | |
| QB 11 | | | | | | | | | | $s_2$ |
| QB 12 | | | | | | | | | | |
| QB 13 | | | | | | | | | | |
| QB 14 | | | | | | | | | | |
| QB 15 | | | | | | | | | | |

Section 1 (QB 1–QB 4)
Section 2 (QB 5–QB 8)
Section 3 (QB 9–QB 12)

# Fig. 18C

EP 2 560 310 A1

| | | | | | | | | | |
|---|---|---|---|---|---|---|---|---|---|
| QB 1 | $b_{1,Re}$ | $b_{1,Im}$ | | | | | | | |
| QB 2 | $b_{2,Re}$ | $b_{2,Im}$ | | | | | | | |
| QB 3 | $b_{1,Re}$ | $b_{1,Im}$ | | | | | | | |
| QB 4 | $b_{2,Re}$ | $b_{2,Im}$ | | | | | | | |
| QB 5 | $b_{3,Re}$ | $b_{3,Im}$ | | | | | | | |
| QB 6 | | | | | | | | | |
| QB 7 | | | | | | | | | |
| QB 8 | | | | | | | | | |
| QB 9 | | | | | | | | | |
| QB 10 | | | | | | | | | |
| QB 11 | | | | | | | | | |
| QB 12 | | | | | | | | | |
| QB 13 | | | | | | | | | |
| QB 14 | | | | | | | | | |
| QB 15 | | | | | | | | | |

$s_1$, $s_2$ — Section 1

$s_1$, $s_2$ — Section 2

$s_1$, $s_2$ — Section 3

Fig. 19C

Fig. 19A

Fig. 19B

# Fig. 20A

Parallel intrleaver with __3 QBs__ per section — 122a

$y_1 \ldots y_6$

DEMUX — 123a

$y_1$ $b_{1,Re}$ / $y_4$ $b_{1,Im}$ → 2-PAM / 2-PAM — 124a-1 → Re / Im → $s_1$

$y_2$ $b_{1,Re}$ / $y_3$ $b_{2,Re}$ / $y_5$ $b_{1,Im}$ / $y_6$ $b_{2,Im}$ → 4-PAM / 4-PAM — 124a-2 → Re / Im → $s_2$

SM Encoder — 125a

$x_1$ ○ Tx 1
$x_2$ ○ Tx 2

# Fig. 20B

Parallel intrleaver with __4 QBs__ per section — 122b

$y_1 \ldots y_8$

DEMUX — 123b

$y_1$ $b_{1,Re}$ / $y_2$ $b_{2,Re}$ / $y_5$ $b_{1,Im}$ / $y_6$ $b_{2,Im}$ → 4-PAM / 4-PAM — 124b-1 → Re / Im → $s_1$

$y_3$ $b_{1,Re}$ / $y_4$ $b_{2,Re}$ / $y_7$ $b_{1,Im}$ / $y_8$ $b_{2,Im}$ → 4-PAM / 4-PAM — 124b-2 → Re / Im → $s_2$

SM Encoder — 125b

$x_1$ ○ Tx 1
$x_2$ ○ Tx 2

# Fig. 20C

EP 2 560 310 A1

Fig. 21

Fig. 22

EP 2 560 310 A1

## Fig. 23A

Section

| | 1 | 2 | 3 | 4 | 5 | 6 | 7 | 8 | 9 | 10 | 11 |
|---|---|---|---|---|---|---|---|---|---|---|---|
| $s_1$ — $b_{1,Re}, b_{1,Im}$ | 6 | 34 | 43 | 12 | 40 | 8 | 7 | 44 | 29 | 23 | 27 |
| $s_1$ — $b_{2,Re}, b_{2,Im}$ | 3 | 20 | 25 | 21 | 13 | 30 | 11 | 39 | 19 | 33 | 14 |
| $s_2$ — $b_{1,Re}, b_{1,Im}$ | 38 | 2 | 28 | 35 | 37 | 9 | 10 | 24 | 36 | 17 | 31 |
| $s_2$ — $b_{2,Re}, b_{2,Im}$ | 4 | 26 | 32 | 41 | 15 | 16 | 42 | 22 | 1 | 18 | 05 |

## Fig. 23B

Section

| | 1 | 2 | 3 | 4 | 5 | 6 | 7 | 8 | 9 | 10 | 11 |
|---|---|---|---|---|---|---|---|---|---|---|---|
| $s_1$ — $b_{1,Re}, b_{1,Im}$ | 6 | 34 | 43 | 12 | 40 | 8 | 10 | 44 | 29 | 23 | 27 |
| $s_1$ — $b_{2,Re}, b_{2,Im}$ | 3 | 20 | 25 | 21 | 13 | 30 | 11 | 39 | 19 | 33 | 14 |
| $s_2$ — $b_{1,Re}, b_{1,Im}$ | 38 | 2 | 28 | 35 | 37 | 9 | 42 | 24 | 36 | 17 | 31 |
| $s_2$ — $b_{2,Re}, b_{2,Im}$ | 4 | 26 | 32 | 41 | 15 | 16 | 07 | 22 | 1 | 18 | 05 |

## Fig. 23C

Section

| | 1 | 2 | 3 | 4 | 5 | 6 | 7 | 8 | 9 | 10 | 11 |
|---|---|---|---|---|---|---|---|---|---|---|---|
| $s_1$ — $b_{1,Re}, b_{1,Im}$ | 10 | 40 | 43 | 29 | 23 | 6 | 44 | 27 | 8 | 34 | 12 |
| $s_1$ — $b_{2,Re}, b_{2,Im}$ | 11 | 19 | 3 | 14 | 30 | 33 | 20 | 25 | 39 | 21 | 13 |
| $s_2$ — $b_{1,Re}, b_{1,Im}$ | 37 | 35 | 31 | 36 | 28 | 38 | 24 | 42 | 17 | 2 | 9 |
| $s_2$ — $b_{2,Re}, b_{2,Im}$ | 41 | 05 | 07 | 15 | 4 | 22 | 32 | 18 | 1 | 16 | 26 |

# Fig. 24A

Tx power ratio: 1/1; bits per channel: 6

| CR | QB Permutations for 6 bits per channel use | | | | | | | | | | | | | | | | | | | | | | | | | | | | | | | | | | | | | | | | | | | | |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| | Section 1 | | | Section 2 | | | Section 3 | | | Section 4 | | | Section 5 | | | Section 6 | | | Section 7 | | | Section 8 | | | Section 9 | | | Section 10 | | | Section 11 | | | Section 12 | | | Section 13 | | | Section 14 | | | Section 15 | | |
| 1/3 | 17 | 5 | 34 | 33 | 28 | 38 | 22 | 13 | 32 | 14 | 44 | 7 | 27 | 23 | 18 | 41 | 10 | 35 | 21 | 15 | 45 | 42 | 26 | 31 | 39 | 29 | 12 | 4 | 1 | 2 | 40 | 36 | 19 | 20 | 43 | 9 | 16 | 3 | 24 | 11 | 37 | 25 | 30 | 8 | 6 |
| 2/5 | 20 | 16 | 34 | 41 | 28 | 36 | 19 | 35 | 42 | 45 | 43 | 2 | 1 | 8 | 30 | 12 | 9 | 14 | 10 | 38 | 15 | 22 | 6 | 5 | 24 | 13 | 31 | 32 | 23 | 27 | 40 | 39 | 18 | 33 | 3 | 29 | 25 | 7 | 21 | 44 | 17 | 26 | 37 | 11 | 4 |
| 7/15 | 13 | 11 | 44 | 41 | 24 | 12 | 16 | 27 | 14 | 22 | 32 | 5 | 17 | 29 | 39 | 6 | 35 | 30 | 10 | 8 | 37 | 3 | 38 | 1 | 7 | 42 | 26 | 15 | 28 | 34 | 9 | 23 | 43 | 4 | 40 | 2 | 20 | 25 | 36 | 21 | 33 | 31 | 18 | 19 | 45 |
| 8/15 | 12 | 27 | 14 | 35 | 13 | 38 | 7 | 39 | 9 | 19 | 43 | 33 | 24 | 25 | 10 | 6 | 45 | 21 | 2 | 28 | 4 | 3 | 17 | 15 | 40 | 42 | 22 | 8 | 41 | 11 | 32 | 16 | 18 | 44 | 31 | 37 | 30 | 26 | 29 | 34 | 36 | 23 | 5 | 20 | 1 |
| 3/5 | 32 | 38 | 25 | 18 | 28 | 34 | 7 | 39 | 15 | 20 | 40 | 44 | 19 | 12 | 29 | 14 | 17 | 21 | 33 | 5 | 24 | 36 | 41 | 31 | 10 | 6 | 27 | 45 | 42 | 37 | 13 | 43 | 11 | 26 | 16 | 22 | 2 | 1 | 3 | 8 | 30 | 9 | 23 | 4 | 35 |
| 2/3 | 19 | 33 | 39 | 10 | 14 | 34 | 27 | 3 | 40 | 20 | 36 | 32 | 16 | 17 | 43 | 7 | 9 | 26 | 11 | 44 | 21 | 5 | 42 | 31 | 6 | 41 | 8 | 4 | 24 | 13 | 25 | 15 | 18 | 23 | 1 | 45 | 30 | 2 | 38 | 12 | 29 | 22 | 35 | 28 | 37 |
| 11/15 | 5 | 35 | 39 | 3 | 25 | 16 | 44 | 17 | 4 | 32 | 13 | 12 | 8 | 26 | 45 | 10 | 6 | 15 | 21 | 40 | 43 | 27 | 24 | 33 | 2 | 28 | 41 | 29 | 19 | 38 | 14 | 20 | 30 | 36 | 7 | 23 | 34 | 1 | 18 | 22 | 42 | 11 | 9 | 37 | 31 |

# Fig. 24B

Tx power ratio: 1/1; bits per channel: 8

| CR | QB Permutations for 8 bits per channel use | | | | | | | | | | | | | | | | | | | | | | | | | | | | | | | | | | | | | | | | | | | | |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| | Section 1 | | | | Section 2 | | | | Section 3 | | | | Section 4 | | | | Section 5 | | | | Section 6 | | | | Section 7 | | | | Section 8 | | | | Section 9 | | | | Section 10 | | | | Section 11 | | | | |
| 1/3 | 9 | 37 | 33 | 39 | 38 | 28 | 14 | 3 | 43 | 36 | 1 | 20 | 4 | 7 | 12 | 6 | 13 | 35 | 8 | 23 | 19 | 32 | 42 | 25 | 41 | 10 | 44 | 30 | 24 | 31 | 40 | 27 | 15 | 26 | 21 | 29 | 5 | 17 | 11 | 34 | 22 | 16 | 18 | 2 | 45 |
| 2/5 | 7 | 21 | 43 | 35 | 27 | 4 | 24 | 5 | 16 | 20 | 30 | 10 | 17 | 42 | 41 | 44 | 15 | 13 | 31 | 36 | 23 | 12 | 37 | 18 | 1 | 19 | 40 | 22 | 29 | 9 | 38 | 8 | 6 | 34 | 14 | 26 | 39 | 3 | 25 | 32 | 28 | 33 | 11 | 2 | 45 |
| 7/15 | 8 | 12 | 38 | 21 | 28 | 19 | 24 | 6 | 31 | 17 | 27 | 20 | 32 | 5 | 35 | 2 | 37 | 1 | 4 | 3 | 43 | 9 | 41 | 33 | 26 | 15 | 39 | 18 | 29 | 11 | 30 | 7 | 44 | 23 | 25 | 16 | 14 | 10 | 34 | 36 | 22 | 42 | 13 | 40 | 45 |
| 8/15 | 17 | 39 | 38 | 26 | 41 | 10 | 33 | 6 | 28 | 5 | 14 | 3 | 42 | 22 | 31 | 43 | 25 | 40 | 44 | 24 | 8 | 1 | 12 | 4 | 29 | 15 | 7 | 20 | 34 | 2 | 36 | 23 | 37 | 16 | 11 | 9 | 30 | 27 | 32 | 21 | 35 | 13 | 18 | 19 | 45 |
| 3/5 | 24 | 3 | 15 | 2 | 40 | 11 | 29 | 18 | 42 | 12 | 34 | 16 | 31 | 21 | 41 | 19 | 44 | 14 | 38 | 25 | 37 | 36 | 32 | 7 | 1 | 28 | 5 | 10 | 33 | 9 | 6 | 17 | 4 | 13 | 39 | 23 | 30 | 26 | 43 | 8 | 35 | 20 | 27 | 22 | 45 |
| 2/3 | 40 | 38 | 36 | 35 | 1 | 23 | 18 | 9 | 24 | 29 | 43 | 27 | 2 | 19 | 3 | 10 | 25 | 20 | 37 | 6 | 4 | 7 | 41 | 39 | 42 | 17 | 14 | 11 | 8 | 22 | 32 | 12 | 28 | 15 | 21 | 5 | 34 | 26 | 13 | 30 | 16 | 33 | 44 | 31 | 45 |
| 11/15 | 15 | 5 | 37 | 20 | 18 | 43 | 1 | 33 | 12 | 29 | 30 | 27 | 21 | 24 | 34 | 4 | 7 | 44 | 41 | 36 | 25 | 16 | 40 | 11 | 19 | 32 | 28 | 23 | 8 | 22 | 38 | 35 | 17 | 2 | 42 | 13 | 14 | 26 | 39 | 3 | 31 | 6 | 10 | 9 | 45 |

# Fig. 24C

Tx power ratio: 1/1; bits per channel: 10

| CR | QB Permutations for 10 bits per channel use | | | | | | | | | | | | | | | | | | | | | | | | | | | | | | | | | | | | | | | | | | | | |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| | Section 1 | | | | | Section 2 | | | | | Section 3 | | | | | Section 4 | | | | | Section 5 | | | | | Section 6 | | | | | Section 7 | | | | | Section 8 | | | | | Section 9 | | | | |
| 1/3 | 27 | 17 | 42 | 8 | 30 | 38 | 6 | 15 | 32 | 36 | 22 | 18 | 40 | 26 | 14 | 41 | 45 | 29 | 23 | 9 | 20 | 4 | 44 | 37 | 2 | 43 | 12 | 11 | 10 | 28 | 21 | 16 | 5 | 13 | 31 | 33 | 3 | 1 | 35 | 7 | 39 | 34 | 24 | 19 | 25 |
| 2/5 | 23 | 27 | 11 | 16 | 42 | 19 | 25 | 44 | 39 | 33 | 34 | 32 | 22 | 35 | 12 | 4 | 2 | 24 | 1 | 10 | 9 | 14 | 28 | 37 | 29 | 36 | 20 | 7 | 8 | 13 | 3 | 17 | 40 | 41 | 31 | 30 | 5 | 6 | 15 | 21 | 45 | 26 | 38 | 43 | 18 |
| 7/15 | 9 | 1 | 33 | 4 | 20 | 16 | 29 | 41 | 38 | 6 | 19 | 14 | 35 | 30 | 39 | 43 | 15 | 27 | 44 | 10 | 11 | 3 | 24 | 18 | 7 | 45 | 8 | 37 | 34 | 22 | 31 | 2 | 40 | 36 | 12 | 32 | 13 | 42 | 25 | 17 | 28 | 21 | 26 | 5 | 23 |
| 8/15 | 27 | 3 | 43 | 12 | 17 | 18 | 8 | 40 | 22 | 15 | 31 | 7 | 41 | 29 | 21 | 30 | 6 | 26 | 28 | 36 | 39 | 9 | 19 | 16 | 32 | 5 | 13 | 24 | 1 | 4 | 10 | 23 | 14 | 35 | 2 | 42 | 37 | 44 | 38 | 34 | 33 | 11 | 45 | 25 | 20 |
| 3/5 | 17 | 28 | 39 | 7 | 14 | 29 | 16 | 35 | 41 | 45 | 2 | 5 | 18 | 1 | 32 | 42 | 13 | 37 | 34 | 21 | 33 | 25 | 40 | 12 | 6 | 30 | 31 | 24 | 8 | 20 | 23 | 4 | 3 | 9 | 11 | 27 | 22 | 38 | 44 | 15 | 10 | 19 | 43 | 36 | 26 |
| 2/3 | 38 | 30 | 11 | 27 | 17 | 16 | 22 | 45 | 21 | 44 | 1 | 23 | 3 | 2 | 35 | 7 | 8 | 12 | 39 | 13 | 40 | 6 | 42 | 36 | 14 | 18 | 34 | 31 | 28 | 24 | 10 | 5 | 15 | 26 | 9 | 20 | 19 | 37 | 32 | 29 | 25 | 33 | 4 | 43 | 41 |
| 11/15 | 27 | 4 | 28 | 37 | 39 | 44 | 8 | 1 | 18 | 41 | 45 | 29 | 42 | 19 | 15 | 34 | 2 | 40 | 17 | 9 | 10 | 33 | 31 | 25 | 35 | 21 | 7 | 30 | 43 | 14 | 3 | 6 | 20 | 22 | 36 | 12 | 32 | 38 | 16 | 5 | 13 | 24 | 26 | 11 | 23 |

# Fig. 25A

Tx power ratio: 1/2; bits per channel: 6

QB Permutations for 6 bits per channel use

| CR | Section 1 | | | Section 2 | | | Section 3 | | | Section 4 | | | Section 5 | | | Section 6 | | | Section 7 | | | Section 8 | | | Section 9 | | | Section 10 | | | Section 11 | | | Section 12 | | | Section 13 | | | Section 14 | | | Section 15 | | |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| 1/3 | 20 | 23 | 40 | 15 | 19 | 21 | 27 | 44 | 9 | 10 | 11 | 36 | 18 | 38 | 32 | 35 | 39 | 31 | 16 | 33 | 42 | 30 | 1 | 7 | 34 | 43 | 45 | 17 | 28 | 22 | 8 | 4 | 2 | 14 | 24 | 41 | 37 | 25 | 12 | 26 | 5 | 3 | 6 | 13 | 29 |
| 2/5 | 20 | 16 | 34 | 41 | 28 | 36 | 19 | 35 | 42 | 45 | 43 | 2 | 1 | 8 | 30 | 12 | 9 | 14 | 10 | 38 | 15 | 22 | 6 | 5 | 24 | 13 | 31 | 32 | 23 | 27 | 40 | 39 | 18 | 33 | 3 | 29 | 25 | 7 | 21 | 44 | 17 | 26 | 37 | 11 | 4 |
| 7/15 | 34 | 13 | 24 | 16 | 40 | 19 | 23 | 38 | 1 | 28 | 36 | 21 | 9 | 6 | 2 | 42 | 44 | 8 | 43 | 33 | 5 | 22 | 41 | 32 | 29 | 45 | 15 | 18 | 26 | 37 | 27 | 31 | 10 | 17 | 30 | 11 | 14 | 20 | 7 | 3 | 35 | 4 | 39 | 25 | 12 |
| 8/15 | 8 | 25 | 22 | 18 | 28 | 20 | 3 | 23 | 4 | 33 | 38 | 19 | 27 | 31 | 11 | 6 | 45 | 24 | 29 | 39 | 7 | 26 | 41 | 2 | 10 | 40 | 32 | 13 | 14 | 9 | 1 | 34 | 5 | 35 | 36 | 21 | 42 | 37 | 12 | 16 | 30 | 17 | 15 | 44 | 43 |
| 3/5 | 31 | 43 | 26 | 20 | 44 | 39 | 18 | 28 | 11 | 37 | 12 | 36 | 34 | 42 | 40 | 9 | 7 | 21 | 22 | 6 | 16 | 27 | 29 | 13 | 8 | 30 | 19 | 38 | 45 | 32 | 4 | 2 | 10 | 5 | 1 | 14 | 17 | 41 | 24 | 35 | 3 | 23 | 15 | 33 | 25 |
| 2/3 | 10 | 24 | 31 | 4 | 5 | 43 | 22 | 34 | 21 | 18 | 36 | 12 | 11 | 9 | 13 | 35 | 41 | 15 | 20 | 29 | 8 | 16 | 2 | 40 | 27 | 25 | 39 | 6 | 33 | 45 | 30 | 28 | 37 | 23 | 1 | 14 | 7 | 3 | 26 | 42 | 44 | 38 | 19 | 17 | 32 |
| 11/15 | 5 | 35 | 39 | 3 | 25 | 16 | 44 | 17 | 4 | 32 | 13 | 12 | 8 | 26 | 45 | 10 | 6 | 15 | 21 | 40 | 43 | 27 | 24 | 33 | 2 | 28 | 41 | 29 | 19 | 38 | 14 | 20 | 30 | 36 | 7 | 23 | 34 | 1 | 18 | 22 | 42 | 11 | 9 | 37 | 31 |

# Fig. 25B

Tx power ratio: 1/2; bits per channel: 8

QB Permutations for 8 bits per channel use

| CR | Section 1 | | | | Section 2 | | | | Section 3 | | | | Section 4 | | | | Section 5 | | | | Section 6 | | | | Section 7 | | | | Section 8 | | | | Section 9 | | | | Section 10 | | | | Section 11 | | | | |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| 1/3 | 4 | 16 | 25 | 1 | 19 | 42 | 36 | 8 | 13 | 34 | 41 | 6 | 37 | 9 | 12 | 17 | 3 | 35 | 32 | 22 | 2 | 39 | 11 | 21 | 14 | 33 | 15 | 23 | 44 | 18 | 26 | 40 | 43 | 24 | 10 | 5 | 28 | 20 | 29 | 31 | 7 | 27 | 30 | 38 | 45 |
| 2/5 | 7 | 21 | 43 | 35 | 27 | 4 | 24 | 5 | 16 | 20 | 30 | 10 | 17 | 42 | 41 | 44 | 15 | 13 | 31 | 36 | 23 | 12 | 37 | 18 | 1 | 19 | 40 | 22 | 29 | 9 | 38 | 8 | 6 | 34 | 14 | 26 | 39 | 3 | 25 | 32 | 28 | 33 | 11 | 2 | 45 |
| 7/15 | 41 | 14 | 33 | 22 | 27 | 10 | 21 | 12 | 35 | 19 | 34 | 8 | 37 | 15 | 5 | 20 | 28 | 24 | 29 | 32 | 11 | 4 | 1 | 3 | 30 | 44 | 6 | 7 | 23 | 42 | 25 | 17 | 26 | 2 | 36 | 13 | 39 | 43 | 38 | 16 | 40 | 9 | 31 | 18 | 45 |
| 8/15 | 28 | 29 | 19 | 22 | 35 | 43 | 44 | 16 | 21 | 38 | 41 | 5 | 27 | 37 | 15 | 42 | 7 | 18 | 9 | 20 | 25 | 10 | 40 | 4 | 34 | 3 | 31 | 2 | 12 | 14 | 6 | 17 | 26 | 8 | 30 | 1 | 33 | 39 | 23 | 13 | 36 | 11 | 32 | 24 | 45 |
| 3/5 | 27 | 20 | 32 | 18 | 41 | 33 | 6 | 12 | 35 | 21 | 14 | 9 | 31 | 37 | 23 | 16 | 42 | 40 | 43 | 13 | 36 | 34 | 26 | 22 | 30 | 28 | 8 | 19 | 1 | 44 | 3 | 38 | 11 | 39 | 10 | 24 | 29 | 25 | 17 | 7 | 5 | 15 | 4 | 2 | 45 |
| 2/3 | 2 | 23 | 3 | 16 | 1 | 12 | 19 | 17 | 30 | 41 | 43 | 24 | 35 | 33 | 22 | 42 | 34 | 13 | 5 | 40 | 15 | 8 | 11 | 32 | 28 | 29 | 36 | 10 | 38 | 39 | 21 | 14 | 44 | 18 | 7 | 26 | 4 | 31 | 9 | 6 | 37 | 27 | 25 | 20 | 45 |
| 11/15 | 15 | 5 | 37 | 20 | 18 | 43 | 1 | 33 | 12 | 29 | 30 | 27 | 21 | 24 | 34 | 4 | 7 | 44 | 41 | 36 | 25 | 16 | 40 | 11 | 19 | 32 | 28 | 23 | 8 | 22 | 38 | 35 | 17 | 2 | 42 | 13 | 14 | 26 | 39 | 3 | 31 | 6 | 10 | 9 | 45 |

# Fig. 25C

Tx power ratio: 1/2; bits per channel: 10

QB Permutations for 10 bits per channel use

| CR | Section 1 | | | | | Section 2 | | | | | Section 3 | | | | | Section 4 | | | | | Section 5 | | | | | Section 6 | | | | | Section 7 | | | | | Section 8 | | | | | Section 9 | | | | |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| 1/3 | 27 | 17 | 42 | 8 | 30 | 38 | 6 | 15 | 32 | 36 | 22 | 18 | 40 | 26 | 14 | 41 | 45 | 29 | 23 | 9 | 20 | 4 | 44 | 37 | 2 | 43 | 12 | 11 | 10 | 28 | 21 | 16 | 5 | 13 | 31 | 33 | 3 | 1 | 35 | 7 | 39 | 34 | 24 | 19 | 25 |
| 2/5 | 23 | 27 | 11 | 16 | 42 | 19 | 25 | 44 | 39 | 33 | 34 | 32 | 22 | 35 | 12 | 4 | 2 | 24 | 1 | 10 | 9 | 14 | 28 | 37 | 29 | 36 | 20 | 7 | 8 | 13 | 3 | 17 | 40 | 41 | 31 | 30 | 5 | 6 | 15 | 21 | 45 | 26 | 38 | 43 | 18 |
| 7/15 | 43 | 20 | 44 | 31 | 7 | 28 | 19 | 26 | 23 | 3 | 40 | 35 | 42 | 22 | 16 | 34 | 21 | 27 | 17 | 4 | 33 | 32 | 2 | 38 | 1 | 39 | 10 | 36 | 11 | 8 | 6 | 24 | 41 | 15 | 5 | 18 | 25 | 45 | 13 | 29 | 14 | 9 | 30 | 37 | 12 |
| 8/15 | 31 | 43 | 28 | 25 | 10 | 36 | 16 | 35 | 38 | 13 | 44 | 20 | 21 | 30 | 15 | 12 | 4 | 24 | 1 | 5 | 7 | 14 | 34 | 45 | 18 | 33 | 11 | 42 | 27 | 9 | 39 | 17 | 26 | 40 | 23 | 32 | 3 | 22 | 41 | 6 | 8 | 19 | 29 | 37 | 2 |
| 3/5 | 17 | 28 | 39 | 7 | 14 | 41 | 16 | 35 | 29 | 45 | 2 | 5 | 18 | 1 | 32 | 37 | 13 | 34 | 42 | 21 | 33 | 12 | 40 | 25 | 6 | 30 | 31 | 24 | 8 | 20 | 23 | 4 | 3 | 9 | 11 | 15 | 27 | 38 | 44 | 22 | 43 | 26 | 36 | 10 | 19 |
| 2/3 | 38 | 30 | 11 | 27 | 17 | 16 | 22 | 45 | 21 | 44 | 1 | 23 | 3 | 2 | 35 | 7 | 8 | 12 | 39 | 13 | 40 | 6 | 42 | 36 | 14 | 18 | 34 | 31 | 28 | 24 | 10 | 5 | 15 | 26 | 9 | 20 | 19 | 37 | 32 | 29 | 25 | 33 | 4 | 43 | 41 |
| 11/15 | 27 | 4 | 28 | 37 | 39 | 44 | 8 | 1 | 18 | 41 | 45 | 29 | 42 | 19 | 15 | 34 | 2 | 40 | 17 | 9 | 10 | 33 | 31 | 25 | 35 | 21 | 7 | 30 | 43 | 14 | 3 | 6 | 20 | 22 | 36 | 12 | 32 | 38 | 16 | 5 | 13 | 24 | 26 | 11 | 23 |

EP 2 560 310 A1

# Fig. 26A

Tx power ratio: 1/4; bits per channel: 6

**QB Permutations for 6 bits per channel use**

| CR | Section 1 | | | Section 2 | | | Section 3 | | | Section 4 | | | Section 5 | | | Section 6 | | | Section 7 | | | Section 8 | | | Section 9 | | | Section 10 | | | Section 11 | | | Section 12 | | | Section 13 | | | Section 14 | | | Section 15 | | |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| 1/3 | 5 | 40 | 3 | 26 | 2 | 9 | 4 | 20 | 17 | 11 | 43 | 16 | 19 | 24 | 39 | 37 | 10 | 44 | 8 | 14 | 22 | 21 | 41 | 45 | 1 | 31 | 35 | 29 | 13 | 34 | 28 | 42 | 32 | 12 | 25 | 18 | 23 | 33 | 38 | 6 | 15 | 27 | 7 | 30 | 36 |
| 2/5 | 20 | 16 | 34 | 41 | 28 | 36 | 19 | 35 | 42 | 45 | 43 | 2 | 1 | 8 | 30 | 12 | 9 | 14 | 10 | 38 | 15 | 22 | 6 | 5 | 24 | 13 | 31 | 32 | 23 | 27 | 40 | 39 | 18 | 33 | 3 | 29 | 25 | 7 | 21 | 44 | 17 | 26 | 37 | 11 | 4 |
| 7/15 | 34 | 13 | 24 | 16 | 40 | 19 | 23 | 38 | 1 | 28 | 36 | 21 | 9 | 6 | 2 | 42 | 44 | 8 | 43 | 33 | 5 | 22 | 41 | 32 | 29 | 45 | 15 | 18 | 26 | 37 | 27 | 31 | 10 | 17 | 30 | 11 | 14 | 20 | 7 | 3 | 35 | 4 | 39 | 25 | 12 |
| 8/15 | 34 | 13 | 24 | 16 | 15 | 18 | 23 | 32 | 1 | 28 | 36 | 21 | 9 | 6 | 2 | 42 | 44 | 8 | 37 | 33 | 5 | 22 | 19 | 14 | 29 | 45 | 40 | 41 | 26 | 43 | 27 | 31 | 10 | 17 | 30 | 11 | 38 | 20 | 7 | 3 | 35 | 4 | 39 | 25 | 12 |
| 3/5 | 23 | 5 | 22 | 42 | 45 | 20 | 43 | 18 | 11 | 27 | 39 | 34 | 41 | 37 | 6 | 24 | 16 | 8 | 30 | 40 | 12 | 35 | 21 | 31 | 36 | 10 | 33 | 44 | 38 | 14 | 4 | 3 | 13 | 9 | 29 | 19 | 32 | 15 | 25 | 28 | 26 | 17 | 1 | 2 | 7 |
| 2/3 | 45 | 39 | 28 | 38 | 16 | 20 | 10 | 8 | 14 | 44 | 35 | 4 | 24 | 34 | 12 | 26 | 32 | 15 | 30 | 22 | 11 | 21 | 43 | 17 | 19 | 13 | 6 | 2 | 5 | 37 | 31 | 42 | 9 | 7 | 40 | 18 | 25 | 1 | 27 | 23 | 3 | 29 | 33 | 41 | 36 |
| 11/15 | 45 | 1 | 39 | 13 | 34 | 18 | 22 | 3 | 19 | 20 | 37 | 17 | 36 | 30 | 27 | 16 | 31 | 2 | 8 | 42 | 35 | 6 | 38 | 33 | 28 | 23 | 9 | 21 | 43 | 4 | 12 | 15 | 29 | 32 | 40 | 24 | 14 | 7 | 5 | 10 | 41 | 44 | 25 | 11 | 26 |

# Fig. 26B

Tx power ratio: 1/4; bits per channel: 8

**QB Permutations for 8 bits per channel use**

| CR | Section 1 | | | | Section 2 | | | | Section 3 | | | | Section 4 | | | | Section 5 | | | | Section 6 | | | | Section 7 | | | | Section 8 | | | | Section 9 | | | | Section 10 | | | | Section 11 | | | | |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| 1/3 | 4 | 16 | 25 | 1 | 19 | 42 | 36 | 8 | 13 | 34 | 41 | 6 | 37 | 9 | 12 | 17 | 3 | 35 | 32 | 22 | 2 | 39 | 11 | 21 | 14 | 33 | 15 | 23 | 44 | 18 | 26 | 40 | 43 | 24 | 10 | 5 | 28 | 20 | 29 | 31 | 7 | 27 | 30 | 38 | 45 |
| 2/5 | 23 | 9 | 28 | 41 | 43 | 27 | 17 | 34 | 42 | 31 | 10 | 5 | 40 | 22 | 15 | 32 | 7 | 39 | 30 | 33 | 36 | 44 | 37 | 18 | 35 | 3 | 14 | 20 | 6 | 2 | 4 | 1 | 19 | 25 | 21 | 12 | 8 | 29 | 13 | 26 | 16 | 24 | 38 | 11 | 45 |
| 7/15 | 35 | 15 | 8 | 5 | 40 | 20 | 42 | 1 | 2 | 11 | 31 | 3 | 41 | 37 | 6 | 10 | 36 | 14 | 34 | 28 | 44 | 22 | 12 | 30 | 29 | 17 | 26 | 27 | 23 | 43 | 9 | 4 | 38 | 18 | 24 | 21 | 32 | 16 | 13 | 39 | 33 | 19 | 25 | 7 | 45 |
| 8/15 | 16 | 24 | 44 | 3 | 39 | 34 | 8 | 11 | 37 | 25 | 26 | 7 | 29 | 43 | 42 | 1 | 35 | 22 | 21 | 17 | 4 | 2 | 33 | 5 | 27 | 10 | 13 | 14 | 36 | 19 | 23 | 9 | 41 | 40 | 32 | 20 | 28 | 18 | 31 | 15 | 30 | 12 | 6 | 38 | 45 |
| 3/5 | 27 | 20 | 32 | 18 | 41 | 33 | 6 | 12 | 35 | 21 | 14 | 9 | 31 | 37 | 23 | 16 | 42 | 40 | 43 | 13 | 36 | 34 | 26 | 22 | 30 | 28 | 8 | 19 | 1 | 44 | 3 | 38 | 11 | 39 | 10 | 24 | 29 | 25 | 17 | 7 | 5 | 15 | 4 | 2 | 45 |
| 2/3 | 2 | 23 | 3 | 16 | 1 | 12 | 19 | 17 | 30 | 41 | 43 | 24 | 35 | 33 | 22 | 42 | 34 | 13 | 5 | 40 | 15 | 8 | 11 | 32 | 28 | 29 | 36 | 10 | 38 | 39 | 21 | 14 | 44 | 18 | 7 | 26 | 4 | 31 | 9 | 6 | 37 | 27 | 25 | 20 | 45 |
| 11/15 | 15 | 5 | 37 | 20 | 18 | 43 | 1 | 33 | 12 | 29 | 30 | 27 | 21 | 24 | 34 | 4 | 7 | 44 | 41 | 36 | 25 | 16 | 40 | 11 | 19 | 32 | 28 | 23 | 8 | 22 | 38 | 35 | 17 | 2 | 42 | 13 | 14 | 26 | 39 | 3 | 31 | 6 | 10 | 9 | 45 |

# Fig. 26C

Tx power ratio: 1/4; bits per channel: 10

**QB Permutations for 10 bits per channel use**

| CR | Section 1 | | | | | Section 2 | | | | | Section 3 | | | | | Section 4 | | | | | Section 5 | | | | | Section 6 | | | | | Section 7 | | | | | Section 8 | | | | | Section 9 | | | | |
|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|---|
| 1/3 | 42 | 30 | 27 | 8 | 17 | 38 | 32 | 36 | 6 | 15 | 26 | 14 | 40 | 18 | 22 | 9 | 45 | 23 | 41 | 29 | 20 | 4 | 44 | 37 | 2 | 43 | 12 | 11 | 10 | 28 | 21 | 16 | 5 | 13 | 31 | 33 | 3 | 1 | 35 | 7 | 24 | 25 | 39 | 34 | 19 |
| 2/5 | 44 | 23 | 13 | 45 | 1 | 2 | 21 | 14 | 4 | 25 | 41 | 20 | 22 | 29 | 19 | 30 | 24 | 17 | 42 | 33 | 27 | 5 | 36 | 11 | 3 | 40 | 8 | 18 | 7 | 35 | 16 | 10 | 38 | 31 | 28 | 43 | 34 | 6 | 12 | 9 | 39 | 26 | 37 | 15 | 32 |
| 7/15 | 39 | 32 | 44 | 31 | 10 | 33 | 19 | 36 | 11 | 4 | 28 | 7 | 18 | 22 | 1 | 41 | 35 | 14 | 13 | 29 | 34 | 2 | 3 | 24 | 9 | 40 | 25 | 30 | 6 | 23 | 43 | 16 | 42 | 37 | 5 | 38 | 21 | 26 | 17 | 12 | 45 | 20 | 27 | 15 | 8 |
| 8/15 | 28 | 25 | 44 | 37 | 8 | 2 | 10 | 38 | 3 | 6 | 13 | 42 | 39 | 35 | 1 | 16 | 41 | 18 | 9 | 17 | 34 | 19 | 27 | 11 | 4 | 33 | 24 | 30 | 23 | 7 | 12 | 14 | 45 | 32 | 15 | 40 | 21 | 36 | 22 | 29 | 43 | 20 | 26 | 31 | 5 |
| 3/5 | 35 | 12 | 38 | 32 | 24 | 28 | 11 | 45 | 23 | 33 | 42 | 14 | 40 | 6 | 31 | 3 | 8 | 17 | 2 | 15 | 19 | 43 | 37 | 20 | 22 | 5 | 18 | 1 | 9 | 4 | 10 | 30 | 41 | 21 | 13 | 44 | 25 | 36 | 34 | 26 | 29 | 39 | 16 | 27 | 7 |
| 2/3 | 38 | 30 | 11 | 27 | 17 | 16 | 22 | 45 | 21 | 44 | 1 | 23 | 3 | 2 | 35 | 7 | 8 | 12 | 39 | 13 | 40 | 6 | 42 | 36 | 14 | 18 | 34 | 31 | 28 | 24 | 10 | 5 | 15 | 26 | 9 | 20 | 19 | 37 | 32 | 29 | 25 | 33 | 4 | 43 | 41 |
| 11/15 | 27 | 4 | 28 | 37 | 39 | 44 | 8 | 1 | 18 | 41 | 45 | 29 | 42 | 19 | 15 | 34 | 2 | 40 | 17 | 9 | 10 | 33 | 31 | 25 | 35 | 21 | 7 | 30 | 43 | 14 | 3 | 6 | 20 | 22 | 36 | 12 | 32 | 38 | 16 | 5 | 13 | 24 | 26 | 11 | 23 |

EP 2 560 310 A1

# Fig. 27

EP 2 560 310 A1

MIMO Decoder

RF Frontend

(OFDM) Demodulator

250-1  240-1  230-1

250-2  240-2  230-2

RF Frontend

(OFDM) Demodulator

SM Decoder

QAM Demapper 1  224-1

QAM Demapper 2  224-2

B₁ bits

B₂ bits

220

225

M U X  223

Bit Deinterleaver  222

LDPC Decoder  221

Europäisches
Patentamt

European
Patent Office

Office européen
des brevets

# EUROPEAN SEARCH REPORT

Application Number

EP 11 00 8671

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | FRANK KIENLE ET AL: "Macro Interleaver Design for Bit Interleaved Coded Modulation with Low-Density Parity-Check Codes", VEHICULAR TECHNOLOGY CONFERENCE, 2008. VTC SPRING 2008. IEEE, IEEE, PISCATAWAY, NJ, USA, 11 May 2008 (2008-05-11), pages 763-766, XP031255631, ISBN: 978-1-4244-1644-8 * sections I and IV * | 1-17 | INV. H04L1/00 |
| A | SONG-NAM HONG ET AL: "Quasi-Cyclic Low-Density Parity-Check Codes for Space-Time Bit-Interleaved Coded Modulation", IEEE COMMUNICATIONS LETTERS, IEEE SERVICE CENTER, PISCATAWAY, NJ, US, vol. 10, no. 10, 1 October 2008 (2008-10-01), pages 767-769, XP011236170, ISSN: 1089-7798, DOI: 10.1109/LCOMM.2008.080902 * section II * | 1,13,14, 16 | |
| A | "IEEE Standard for Local and metropolitan area networks Part 16: Air Interface for Broadband Wireless Access Systems;IEEE Std 802.16-2009 (Revision of IEEE Std 802.16-2004)", STANDARD NO.: IEEE STD 802.16-2009 (2009) - 29 MAY 2009, IEEE, NEW YORK, NY, USA, 29 May 2009 (2009-05-29), pages C1-2004, XP017604205, ISBN: 978-0-7381-5919-5 * sections 8.4.9.3 and 8.4.9.4 * | 1-17 | TECHNICAL FIELDS SEARCHED (IPC)<br>H04L |

-/--

The present search report has been drawn up for all claims

| Place of search | Date of completion of the search | Examiner |
|---|---|---|
| The Hague | 1 March 2012 | Xu, Yuhuan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt
European
Patent Office
Office européen
des brevets

**EUROPEAN SEARCH REPORT**

Application Number

EP 11 00 8671

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | "Digital Video Broadcasting (DVB); Second generation framing structure, channel coding and modulation systems for Broadcasting, Interactive Services, News Gathering and other broadband satellite applications (DVB-S2)", EUROPEAN STANDARD (TELECOMMUNICATIONS SERIES), EUROPEAN TELECOMMUNICATIONS STANDARDS INSTITUTE (ETSI), 650, ROUTE DES LUCIOLES ; F-06921 SOPHIA-ANTIPOLIS ; FRANCE, no. V 1.2.1, 1 August 2009 (2009-08-01), XP002670633, * sections 5.3.2, 5.3.3 and 5.4 * ----- | 1-17 | |
| | | | TECHNICAL FIELDS SEARCHED (IPC) |

The present search report has been drawn up for all claims

| Place of search | Date of completion of the search | Examiner |
|---|---|---|
| The Hague | 1 March 2012 | Xu, Yuhuan |

CATEGORY OF CITED DOCUMENTS

X : particularly relevant if taken alone
Y : particularly relevant if combined with another
　document of the same category
A : technological background
O : non-written disclosure
P : intermediate document

T : theory or principle underlying the invention
E : earlier patent document, but published on, or
　after the filing date
D : document cited in the application
L : document cited for other reasons

& : member of the same patent family, corresponding
　document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 11006087 A